(19) Europäisches Patentamt
European Patent Office
Office européen des brevets

(11) EP 3 439 056 A1

(12) **EUROPEAN PATENT APPLICATION**
published in accordance with Art. 153(4) EPC

(43) Date of publication:
**06.02.2019 Bulletin 2019/06**

(21) Application number: **17773739.2**

(22) Date of filing: **13.02.2017**

(51) Int Cl.:
***H01L 51/44*** (2006.01) ***C07F 7/12*** (2006.01)
***H01L 51/48*** (2006.01)

(86) International application number:
**PCT/JP2017/005126**

(87) International publication number:
**WO 2017/169191 (05.10.2017 Gazette 2017/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **30.03.2016 JP 2016068690**
**30.05.2016 JP 2016107853**
**15.07.2016 JP 2016140828**

(71) Applicant: **FUJIFILM Corporation**
**Tokyo 106-8620 (JP)**

(72) Inventors:
- **SATO, Hirotaka**
**Ashigarakami-gun**
**Kanagawa 258-8577 (JP)**
- **SHIROKANE, Kenji**
**Ashigarakami-gun**
**Kanagawa 258-8577 (JP)**
- **ISE, Toshihiro**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

# (54) PHOTOELECTRIC CONVERSION ELEMENT, SOLAR CELL, METHOD FOR MANUFACTURING PHOTOELECTRIC CONVERSION ELEMENT, SURFACE TREATMENT AGENT, SURFACE TREATMENT COMPOSITION, AND SURFACE TREATMENT FLUID

(57) Provided is a photoelectric conversion element that uses a perovskite compound as a light absorbing agent and in which a moisture resistance variation is small; a solar cell that uses this photoelectric conversion element; a method for manufacturing a photoelectric conversion element; a surface treating agent; a composition for surface treatment; and a surface treatment solution. A photoelectric conversion element includes, in this order: a first electrode that includes a photosensitive layer containing a light absorbing agent on a conductive support; a compound layer that contains a surface treating agent and is provided on a surface of the photosensitive layer; and a second electrode, in which the light absorbing agent contains a compound having a perovskite-type crystal structure that has a cation of an element of Group 1 in the periodic table or a cationic organic group A, a cation of a metal atom M other than elements of Group 1 in the periodic table, and an anion of an anionic atom or atomic group X, and the surface treating agent contains a silyl group.

EP 3 439 056 A1

FIG. 1A

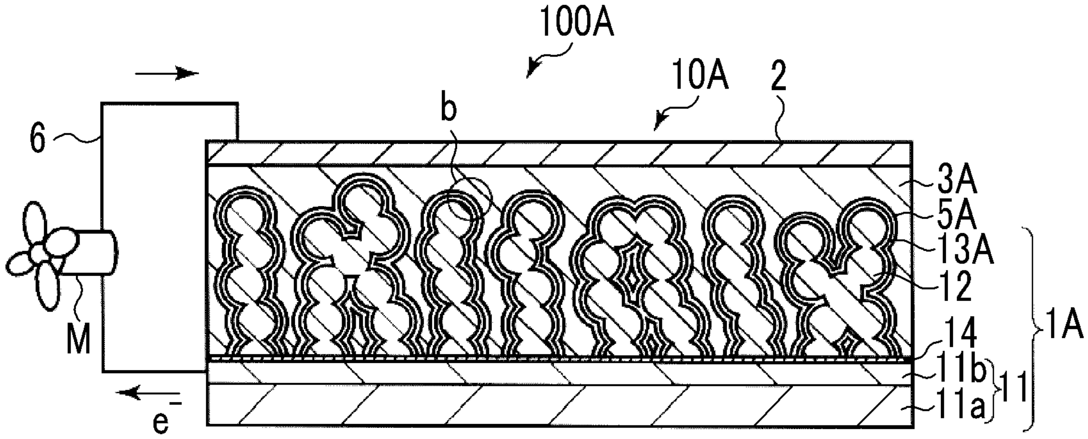

## Description

## BACKGROUND OF THE PRESENT INVENTION

1. Field of the present invention

The present invention relates to a photoelectric conversion element, a solar cell, a method for manufacturing a photoelectric conversion element, a surface treating agent, a composition for surface treatment, and a surface treatment solution.

2. Description of the Related Art

Photoelectric conversion elements are used in a variety of optical sensors, copiers, solar cells, and the like. It is expected that solar cells will be actively put into practical use as cells using non-exhaustible solar energy. Among these, research and development of dye sensitized solar cells, in which an organic dye, a Ru bipyridyl complex, or the like is used as a sensitizer, are actively in progress, and the photoelectric conversion efficiency thereof reaches approximately 11%.

Meanwhile, in recent years, there have been reported research results indicating that solar cells using a metal halide as a compound (perovskite compound) having a perovskite-type crystal structure are capable of achieving relatively high conversion efficiency, and the solar cells attract attention.

For example, a solar cell using a metal halide represented by $CH_3NH_3PbI_2Cl$ as a light absorbing agent is described in Science, 338, p. 643 to 647 (2012).

It is described in JP2006-024565A that in a solar cell having a dye sensitized oxide semiconductor electrode, an oxide semiconductor film is treated with a silanizing agent containing a partial structure $R^1$-Si-$OR^2$.

## SUMMARY OF THE PRESENT INVENTION

As described above, in a photoelectric conversion element which uses a metal halide perovskite compound, constant achievement is attained in an improvement of photoelectric conversion efficiency. Because it has not been long since this photoelectric conversion element has been developed, sufficient research and investigation have not been conducted on element performance.

Under such a circumstance, when photoelectric conversion elements are manufactured by repeating the same method using a metal halide perovskite compound, it was found that, from the viewpoint of realizing stability of battery performance, there was a problem that a variation (moisture resistance variation) in photoelectric conversion efficiency between the obtained photoelectric conversion elements under the high-humidity environment becomes large.

Therefore, an object of the present invention is to provide a photoelectric conversion element in which a moisture resistance variation is small, and battery performance is stably exhibited, and a solar cell using this photoelectric conversion element. Another object of the present invention is to provide a method for manufacturing a photoelectric conversion element in which a moisture resistance variation is small, a surface treating agent used for such a photoelectric conversion element, a composition for surface treatment, and a surface treatment solution.

The present inventors have found that a photoelectric conversion element in which a moisture resistance variation is small can be obtained by providing, on a surface of the photosensitive layer, a compound layer that contains a surface treating agent having a silyl group, in a photoelectric conversion element including a photosensitive layer that contains a light absorbing agent having a perovskite compound having a perovskite-type crystal structure. The present invention has been completed through investigation based on these findings.

That is, the above-described problem has been solved by the following means.

<1> A photoelectric conversion element comprises, in this order: a first electrode that includes a photosensitive layer containing a light absorbing agent on a conductive support; a compound layer that contains a surface treating agent and is provided on a surface of the photosensitive layer; and a second electrode, in which the light absorbing agent contains a compound having a perovskite-type crystal structure that has a cation of an element of Group 1 in the periodic table or a cationic organic group A, a cation of a metal atom M other than elements of Group 1 in the periodic table, and an anion of an anionic atom or atomic group X, and the surface treating agent contains a silyl group.

<2> The photoelectric conversion element according to <1>, in which the surface treating agent is represented by Formula (A-0).

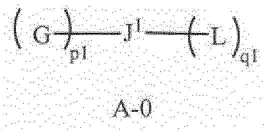

A-0

In Formula (A-0), G represents a group or a salt selected from the group consisting of $-OR^a$, $-O^-Ya^+$, $-SR^a$, $-S^-Ya^+$, $-NR^aR^b$, $-(NR^aR^bR^c)^+Ya^-$, $-COOR^a$, $-COO^-Ya^+$, $-SO_3R^a$, $-SO_3^-Ya^+$, $-P(=O)(OR^a)_2$, $-P(=O)(O^-Ya^+)_2$, $-B(OR^a)_2$, and $-B(OR^a)_3^-Ya^+$. $R^a$, $R^b$, and $R^c$ each independently represent a hydrogen atom or a substituent. Ya represents a counter salt. p1 represents an integer of 1 or more. L represents a silyl group. q1 represents an integer of 1 or more. $J^1$ represents a single bond or a linking group.

<3> The photoelectric conversion element according to <2>, in which the surface treating agent is represented by Formula (A-1) or (A-2).

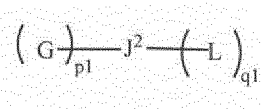

A-1

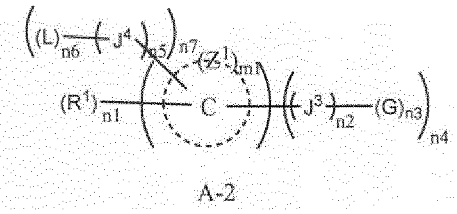

A-2

G, p1, L, and q1 of Formula (A-1) and Formula (A-2) are the same as G, p1, L, and q1 of Formula (A-0).

In Formula (A-1), $J^2$ represents a single bond or a linking group not containing a hydrocarbon ring or a hetero ring. In Formula (A-2), ring C represents a hydrocarbon ring or a hetero ring. $Z^1$ represents a hetero atom or $NR^{12}$. $R^{12}$ represents a hydrogen atom or a substituent. ml represents an integer of 0 or more. $R^1$ represents a substituent. n1 represents an integer of 0 or more. $J^3$ represents a single bond or a linking group. n2 represents an integer of 0 or more. n3 represents an integer of 1 or more. n4 represents an integer of 1 or more. $J^4$ represents a single bond or a linking group. n5 represents an integer of 0 or more. n6 represents an integer of 1 or more. n7 represents an integer of 1 or more.

<4> The photoelectric conversion element according to <3>, in which in Formula (A-1), L is represented by Formula (L-1).

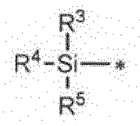

Formula L-1

In Formula, $R^3$ to $R^5$ each independently represent an alkyl group, an alkenyl group, an alkynyl group, a hydrocarbon ring group, or a heterocyclic group. * represents a linking site with $J^2$.

<5> The photoelectric conversion element according to <3>, in which in Formula (A-2), L is represented by Formula (L-1).

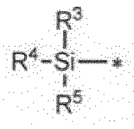

Formula L-1

In Formula, $R^3$ to $R^5$ each independently represent an alkyl group, an alkenyl group, an alkynyl group, a hydrocarbon ring group, or a heterocyclic group. * represents a linking site with $J^4$ or ring C.

<6> The photoelectric conversion element according to any one of <3> to <5>, in which in Formula (A-1), $J^2$ is a linking group selected from the group consisting of an alkylene group, an alkenylene group, an alkynylene group, and a combination of these groups.

<7> The photoelectric conversion element according to any one of <3> to <6>, in which in Formula (A-2), $J^4$ is a linking group selected from the group consisting of an alkylene group, a cycloalkylene group, an alkenylene group, a cycloalkenylene group, an alkynylene group, an arylene group, a heteroarylene group, and a combination of these groups.

<8> The photoelectric conversion element according to any one of <2> to <7>, in which in Formula (A-0), (A-1), or (A-2), G is selected from the group consisting of $-OR^a$, $-O^-Ya^+$, $-SR^a$, $-S^-Ya^+$, $-NR^aR^b$, and $-(NR^aR^bR^c)^+Ya^-$.

<9> The photoelectric conversion element according to any one of <1> to <8>, in which the surface treating agent is represented by Formula (A-5).

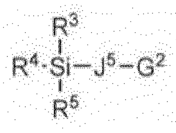
Formula A-5

In Formula (A-5), $J^5$ represents a linking group selected from the group consisting of an alkylene group, an arylene group, and a combination of these groups, and $G^2$ represents $-NR^aR^b$ or $-(NR^aR^bR^c)^+Ya^-$. $R^a$, $R^b$, and $R^c$ each independently represent a hydrogen atom or a substituent. Ya represents a counter salt. $R^3$ to $R^5$ each independently represent an alkyl group, an alkenyl group, an alkynyl group, a hydrocarbon ring group, or a heterocyclic group.

<10> A solar cell that uses the photoelectric conversion element according to any one of <1> to <9>.

<11> A method for manufacturing a photoelectric conversion element including a first electrode that has, on a conductive support, a photosensitive layer containing, as a light absorbing agent, a compound having a perovskite-type crystal structure that has a cation of an element of Group 1 in the periodic table or a cationic organic group A, a cation of a metal atom M other than elements of Group 1 in the periodic table, and an anion of an anionic atom or atomic group X, and a second electrode in this order, the method comprising: bringing the first electrode into contact with a solution containing a compound represented by Formula (A-0).

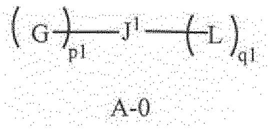
A-0

In Formula (A-0), G represents a group or a salt selected from the group consisting of $-OR^a$, $-O^-Ya^+$, $-SR^a$, $-S^-Ya^+$, $-NR^aR^b$, $-(NR^aR^bR^c)^+Ya^-$, $-COOR^a$, $-COO^-Ya^+$, $-SO_3R^a$, $-SO_3^-Ya^+$, $-P(=O)(OR^a)_2$, $-P(=O)(O^-Ya^+)_2$, $-B(OR^a)_2$, and $-B(OR^a)_3^-Ya^+$. $R^a$, $R^b$, and $R^c$ each independently represent a hydrogen atom or a substituent. Ya represents a counter salt. p1 represents an integer of 1 or more. L represents a silyl group. q1 represents an integer of 1 or more. $J^1$ represents a single bond or a linking group.

<12> A surface treating agent that is represented by Formula (A-1) or (A-2).

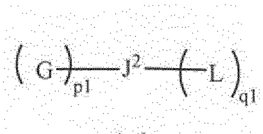
A-1

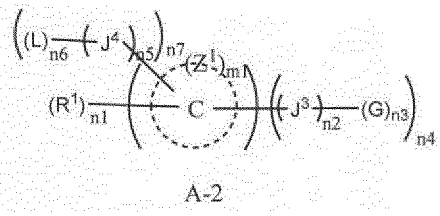
A-2

In Formula (A-1), G represents a group or a salt selected from the group consisting of $-OR^a$, $-O^-Ya^+$, $-SR^a$, $-S^-Ya^+$, $-NR^aR^b$, $-(NR^aR^bR^c)^+Ya^-$, $-COOR^a$, $-COO^-Ya^+$, $-SO_3R^a$, $-SO_3^-Ya^+$, $-P(=O)(OR^a)_2$, $-P(=O)(O^-Ya^+)_2$, $-B(OR^a)_2$, and $-B(OR^a)_3^-Ya^+$. $R^a$, $R^b$, and $R^c$ each independently represent a hydrogen atom or a substituent. Ya represents a counter salt. p1 represents an integer of 1 or more. L represents a silyl group. q1 represents an integer of 1 or more. $J^2$ represents a single bond or a linking group not containing a hydrocarbon ring or a hetero ring.

In Formula (A-2), G represents a group or a salt selected from the group consisting of $-OR^a$, $-O^-Ya^+$, $-SR^a$, $-S^-Ya^+$, $-NR^aR^b$, $-(NR^aR^bR^c)^+Ya^-$, $-COOR^a$, $-COO^-Ya^+$, $-SO_3R^a$, $-SO_3^-Ya^+$, $-P(=O)(OR^a)_2$, $-P(=O)(O^-Ya^+)_2$, $-B(OR^a)_2$, and $-B(OR^a)_3^-Ya^+$. $R^a$, $R^b$, and $R^c$ each independently represent a hydrogen atom or a substituent. Ya represents a counter salt. L represents a silyl group. ring C represents a hydrocarbon ring or a hetero ring. $Z^1$ represents a hetero atom or $NR^{12}$. $R^{12}$ represents a hydrogen atom or a substituent. ml represents an integer of 0 or more. $R^1$ represents a substituent. n1 represents an integer of 0 or more. $J^3$ represents a single bond or a linking group. n2 represents an integer of 0 or more. n3 represents an integer of 1 or more. n4 represents an integer of 1 or more. $J^4$ represents a single bond or a linking group. n5 represents an integer of 0 or more. n6 represents an integer of 1 or more. n7 represents an integer of 1 or more.

<13> A composition for surface treatment, comprising: the surface treating agent according to <12>; and an additive that has an element of Group 1 in the periodic table or a cationic organic group A.
<14> The composition for surface treatment according to <13>, in which the cationic organic group A is a cationic organic group represented by Formula (1).

Formula (1): $R^{1a}\text{-}NH_3^+$

In Formula, $R^{1a}$ represents a substituent or Formula (2).

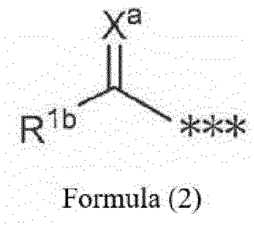

Formula (2)

In Formula (2), $X^a$ represents $NR^{1c}$, an oxygen atom, or a sulfur atom. $R^{1b}$ and $R^{1c}$ each independently represent a hydrogen atom or a substituent. *** represents a binding site with a nitrogen atom in Formula (1).
<15> The composition for surface treatment according to <14>, in which $R^{1a}$ in Formula (1) is a group represented by Formula (2).
<16> A surface treatment solution, comprising: the surface treating agent according to <12> or the composition for surface treatment according to any one of <13> to <15>; and an aprotic solvent.

According to the present invention, it is possible to provide a photoelectric conversion element in which a moisture resistance variation is small, and a solar cell. In addition, according to the present invention, it is possible to provide a method for a photoelectric conversion element in which a moisture resistance variation is small, a surface treating agent used for such a photoelectric conversion element, a composition for surface treatment, and a surface treatment solution.

**BRIEF DESCRIPTION OF THE DRAWINGS**

Fig. 1A is a cross-sectional view schematically illustrating a preferred aspect of a photoelectric conversion element of the present invention.
Fig. 1B is an enlarged view of a circular portion in Fig. 1A.
Fig. 2 is a cross-sectional view schematically illustrating another preferred aspect of the photoelectric conversion element having a thick photosensitive layer of the present invention.
Fig. 3 is a cross-sectional view schematically illustrating still another preferred aspect of the photoelectric conversion element of the present invention.
Fig. 4 is a cross-sectional view schematically illustrating still another preferred aspect of the photoelectric conversion element of the present invention.
Fig. 5 is a cross-sectional view schematically illustrating still another preferred aspect of the photoelectric conversion element of the present invention.
Fig. 6 is a cross-sectional view schematically illustrating still another preferred aspect of the photoelectric conversion element of the present invention.
Fig. 7A is a schematic view illustrating a cation of a metal atom M other than elements of Group 1 in the periodic table (M cation), a cation of an element of Group 1 in the periodic table or a cationic organic group A (A cation), and an anion of an anionic atom or atomic group X (X anion) constituting the photosensitive layer in the photoelectric conversion element of the present invention, and a surface treating agent constituting a compound layer.
Fig. 7B is a schematic view illustrating a perovskite structure of the photosensitive layer in the photoelectric conversion element of the present invention.
Fig. 7C is a schematic view illustrating an example of an aspect of the compound layer in the photosensitive layer surface in the photoelectric conversion element of the present invention.
Fig. 7D is a schematic view illustrating an example of another aspect of the compound layer in the photosensitive

layer surface in the photoelectric conversion element of the present invention.

Fig. 7E is a schematic view illustrating an example of still another aspect of the compound layer in the photosensitive layer surface in the photoelectric conversion element of the present invention.

Fig. 7F is a schematic view illustrating an example of still another aspect of the compound layer in the photosensitive layer surface in the photoelectric conversion element of the present invention.

## DESCRIPTION OF THE PREFERRED EMBODIMENTS

In this specification, parts of respective formulae may be expressed as a rational formula for understanding of chemical structures of compounds. According to this, in the respective formulae, partial structures are called (substituent) groups, ions, atoms, and the like, but in this specification, the partial structures may represent element groups or elements which constitute (substituent) groups or ions represented by the formulae in addition to the (substituent) groups, the ions, the atoms, and the like.

In this specification, with regard to expression of compounds (including a complex and a dye), the expression is also used to indicate salts of the compounds and ions of the compounds in addition to the compounds. In addition, with regard to compounds for which substitution or non-substitution is not specified, the compounds also include compounds which have an arbitrary substituent in a range exhibiting a desired effect. This is also true of substituents, linking groups, and the like (hereinafter, referred to as "substituents and the like").

In this specification, in a case where a plurality of substituents and the like expressed using specific symbols or a plurality of substituents and the like are simultaneously defined, the respective substituents and the like may be identical to or different from each other unless otherwise stated. This is also true of definition of the number of substituents and the like. In addition, in a case of approaching each other (particularly, in a case of being close to each other), the plurality of substituents and the like may be bonded to each other to form a ring unless otherwise stated. In addition, rings, for example, alicycles, aromatic rings, and hetero rings may be additionally fused together to form a fused ring.

In this specification, numerical ranges represented by using "to" include ranges including numerical values before and after "to" as the lower limit and the upper limit.

«Photoelectric Conversion Element»

A photoelectric conversion element of the present invention includes, in this order: a first electrode that includes a photosensitive layer containing a light absorbing agent on a conductive support; a compound layer that contains a surface treating agent and is provided on a surface of the photosensitive layer; and a second electrode, in which a surface treating agent has a silyl group.

In the present invention, the aspect in which the photosensitive layer is provided on the conductive support includes an aspect in which the photosensitive layer is provided to be in contact with a surface of the conductive support, and an aspect in which the photosensitive layer is provided on an upper side of the surface of the conductive support through another layer.

In the aspect in which the photosensitive layer is provided on the upper side of the surface of the conductive support through another layer, as the other layer that is provided between the conductive support and the photosensitive layer, there is no particular limitation as long as the other layer does not deteriorate a battery performance of the photoelectric conversion element. Examples thereof include a porous layer, a blocking layer, an electron transport layer, a hole transport layer, and the like.

In the present invention, examples of the aspect in which the photosensitive layer is provided on the upper side of the surface of the conductive support through another layer includes an aspect in which the photosensitive layer is provided on a surface of the porous layer in a thin film shape (refer to Fig. 1A), an aspect in which the photosensitive layer is provided on the surface of the porous layer in a thick shape (refer to Fig. 2 and Fig. 6), an aspect in which the photosensitive layer is provided on a surface of the blocking layer in a thin shape, an aspect in which the photosensitive layer is provided on the surface of the blocking layer in a thick film shape (refer to Fig. 3), an aspect in which the photosensitive layer is provided on a surface of the electron transport layer in a thin film shape or a thick film shape (refer to Fig. 4), and an aspect in which the photosensitive layer is provided on a surface of the hole transport layer in a thin film shape or a thick film shape (refer to Fig. 5). The photosensitive layer may be provided in a linear shape or in a dispersed pattern, but is preferably provided in a film shape.

In the present invention, the surface of the photosensitive layer surface means a surface on a side of the second electrode of the photosensitive layer. In the present invention, the phrase "the compound layer having the surface treating agent which is provided on the photosensitive layer surface" means that the compound layer is present on the surface or in the vicinity of the photosensitive layer. The aspect in which the compound layer is present includes a case in which the surface treating agent is bonded to, in close contact with, fixed to, held to be carried by, adsorbed to, or the like, the surface of the photosensitive layer by a chemical bonding or a physical interaction. Examples of the aspect include an

aspect in which the surface treating agent is covalently bonded, ionically bonded, or coordinate bonded to the surface of the photosensitive layer, an aspect in which the surface treating agent is physically adsorbed to the surface of the photosensitive layer, or an aspect in which the surface treating agent is replaced with a part of materials of the photosensitive layer. In the present invention, in which manner the compound layer having the surface treating agent is present on the surface of the photosensitive layer is not limited, as long as the compound layer having the surface treating agent is present on the surface or in the vicinity of the photosensitive layer.

For example, an aspect in which a compound layer 5 having the surface treating agent is present within pores of the porous layer may be adopted, or an aspect in which some of the surface treating agent forming the compound layer 5 is incorporated into a photosensitive layer 13 may be adopted. Furthermore, some of the surface treating agent forming the compound layer 5 may be incorporated into the photosensitive layer 13 so that some of the surface treating agent becomes a part of perovskite components. In the present invention, regardless of the aspect of the surface treating agent on the surface of the photosensitive layer, aggregation of the surface treating agent present on the surface of the photosensitive layer is referred to as the compound layer for the purpose of convenience. As such, as long as the compound layer having the surface treating agent is present on the surface of the photosensitive layer 13, the compound layer may be in any of a film form, a linear form, and a dispersed form, or may be in a mixed form thereof. The compound layer may not necessarily form a layer or a film which uniformly covers the surface of the photosensitive layer, but the compound layer is preferably provided in a form of a monolayer.

The form of the compound layer on the surface of the photosensitive layer will be described later in detail with reference to the drawings.

In the present invention, a layer to be provided to be in contact with the compound layer is not particularly limited. The layer to be provided to be in contact with the compound layer may be a layer configuring the photoelectric conversion element, and examples thereof include a (solid) hole transport layer, an electron transport layer, a second electrode, and the like.

In the photoelectric conversion element of the present invention, the photosensitive layer and the compound layer may be present in various forms according to a form of an underlayer to which the photosensitive layer and the compound layer are to be provided, an amount of the light absorbing agent or the surface treating agent to be used, and the like. Therefore, in the present invention, the photosensitive layer and the compound layer may be in any forms.

In the photoelectric conversion element of the present invention, a configuration other than a configuration defined in the present invention is not particularly limited, and it is possible to employ a configuration that is known with respect to the photoelectric conversion element and a solar cell. Respective layers, which constitute the photoelectric conversion element of the present invention, are designed in correspondence with the purposes thereof, and may be formed, for example, in a monolayer or multilayers. For example, the porous layer may be provided between the conductive support and the photosensitive layer (refer to Fig. 1A, Fig. 2, and Fig. 6).

Hereinafter, description will be given of preferred aspects of the photoelectric conversion element of the present invention.

In Fig. 1A, Fig. 1B, and Fig. 2 to Fig. 6, the same reference numeral represents the same constituent element (member).

Furthermore, in Fig. 1A, Fig. 2, and Fig. 6, the size of fine particles which form a porous layer 12 is illustrated in a highlighted manner. These fine particles are preferably packed with each other (are vapor-deposited or in close contact with each other) in the horizontal direction and the vertical direction with respect to a conductive support 11 to form a porous structure.

In this specification, simple description of "photoelectric conversion element 10" represents photoelectric conversion elements 10A to 10F unless otherwise stated. The same applies to a system 100 and a first electrode 1. In addition, simple description of "photosensitive layer 13 or compound layer 5" represents photosensitive layers 13A to 13C or compound layers 5A to 5C unless otherwise stated. Similarly, description of "hole transport layer 3" represents hole transport layers 3A and 3B unless otherwise stated.

Examples of a preferred aspect of the photoelectric conversion element of the present invention include the photoelectric conversion element 10A illustrated in Fig. 1A. A system 100A illustrated in Fig. 1A is a system in which the photoelectric conversion element 10A is applied to a cell that allows operation means M (for example, an electric motor) to operate with an external circuit 6.

The photoelectric conversion element 10A includes a first electrode 1A, a compound layer 5A on a photosensitive layer 13A of the first electrode 1A, a second electrode 2, and a hole transport layer 3A between the compound layer 5A and the second electrode 2.

The first electrode 1A has the conductive support 11 formed of a support 11a and a transparent electrode 11b, the porous layer 12, and the photosensitive layer 13A that is provided on the porous layer 12. As schematically illustrated in Fig. 1B in which a cross-sectional region b in Fig. 1A is enlarged, the photosensitive layer 13A is provided on a surface of the porous layer 12. In Fig. 1A, a blocking layer 14 is provided on the transparent electrode 11b, and the porous layer 12 is formed on the blocking layer 14. As described above, in the photoelectric conversion element 10A including the

porous layer 12, it is assumed that a surface area of the photosensitive layer 13A increases, and thus charge separation and charge migration efficiency are improved.

A photoelectric conversion element 10B illustrated in Fig. 2 schematically illustrates a preferred aspect in which the photosensitive layer 13A of the photoelectric conversion element 10A illustrated in Fig. 1A is provided to be thick. In Fig. 2, a compound layer 5B is provided on the surface of the photosensitive layer 13A provided to be thick. In the photoelectric conversion element 10B, the hole transport layer 3B is provided to be thin. The photoelectric conversion element 10B is different from the photoelectric conversion element 10A illustrated in Fig. 1A in the film thickness of the photosensitive layer 13B and the hole transport layer 3B, but the photoelectric conversion element 10B has the same configuration as that of the photoelectric conversion element 10A except for the difference.

A photoelectric conversion element 10C illustrated in Fig. 3 schematically illustrates another preferred aspect of the photoelectric conversion element of the present invention. The photoelectric conversion element 10C is different from the photoelectric conversion element 10B illustrated in Fig. 2 in that the porous layer 12 is not provided, but the photoelectric conversion element 10C has the same configuration as that of the photoelectric conversion element 10B except for the difference. That is, in the photoelectric conversion element 10C, the photosensitive layer 13C is formed on the surface of the blocking layer 14 in a thick film shape, and the compound layer 5C is formed on the surface of the photosensitive layer 13C. In the photoelectric conversion element 10C, the hole transport layer 3B may be provided to be thick in the same manner as in the hole transport layer 3A.

A photoelectric conversion element 10D illustrated in Fig. 4 schematically illustrates still another preferred aspect of the photoelectric conversion element of the present invention. In Fig. 4, the compound layer 5C of the photoelectric conversion element 10D is the same as the compound layer 5C of the photoelectric conversion element 10C shown in Fig. 3. The photoelectric conversion element 10D is different from the photoelectric conversion element 10C illustrated in Fig. 3 in that an electron transport layer 15 is provided instead of the blocking layer 14, but the photoelectric conversion element 10D has the same configuration as that of the photoelectric conversion element 10C except for the difference. The first electrode 1D includes the conductive support 11, and the electron transport layer 15 and the photosensitive layer 13C which are sequentially formed on the conductive support 11. The photoelectric conversion element 10D is preferable when considering that the respective layers can be formed from an organic material. According to this, the productivity of the photoelectric conversion element is improved, and thickness reduction or flexibilization becomes possible.

A photoelectric conversion element 10E illustrated in Fig. 5 schematically illustrates still another preferred aspect of the photoelectric conversion element of the present invention. In Fig. 5, the compound layer 5C of the photoelectric conversion element 10E is the same as the compound layer 5C of the photoelectric conversion element 10C shown in Fig. 3 except that on the surface thereof, the electron transport layer 4 is formed instead of the hole transport layer 3B. A system 100E including the photoelectric conversion element 10E is a system that is applied to battery use in the same manner as in the system 100A.

The photoelectric conversion element 10E includes a first electrode 1E, the compound layer 5C on the photosensitive layer 13C of the first electrode 1E, the second electrode 2, and the electron transport layer 4 provided between the compound layer 5C and the second electrode 2. The first electrode 1E includes the conductive support 11, and a hole transport layer 16 and the photosensitive layer 13C which are formed on the conductive support 11 in this order. The photoelectric conversion element 10E is preferable when considering that respective layers can be formed from an organic material in the same manner as in the photoelectric conversion element 10D.

A photoelectric conversion element 10F illustrated in Fig. 6 schematically illustrates still another preferred aspect of the photoelectric conversion element of the present invention. The photoelectric conversion element 10F is different from the photoelectric conversion element 10B illustrated in Fig. 2 in that the hole transport layer 3B is not provided, but the photoelectric conversion element 10F has the same configuration as that of the photoelectric conversion element 10B except for the difference.

Next, with reference to Figs. 7A to 7E, the aspect of the compound layer having the surface treating agent having a silyl group, the layer being provided on the surface of the photosensitive layer will be described in detail.

Symbols shown in Fig. 7A indicate a cation of an element of Group 1 in the periodic table or a cationic organic group A (abbreviated as A cation), a cation of a metal atom M other than elements of Group 1 in the periodic table (abbreviated as M cation), an anion of an anionic atom or atom atomic group X (abbreviated as X anion), and the surface treating agent.

Fig. 7B is a schematic view illustrating a perovskite structure of the photosensitive layer 13B by using the symbols of the A cation, the M cation, and the X anion shown in Fig. 7A.

In the present invention, as the aspect of the compound layer having the surface treating agent, which is provided on the surface of the photosensitive layer, a first aspect to a third aspect shown below are considered.

(1) First Aspect of Compound Layer

The first aspect of the compound layer in the surface of the photosensitive layer is shown in Fig. 7C. In Fig. 7C, on the surface of the photosensitive layer 13B having the perovskite structure, the surface treating agent forms a monolayer or is laminated to form the compound layer 5B. n in Fig. 7C represents the number of laminate of the surface treating agent.

(2) Second Aspect of Compound Layer

The second aspect of the compound layer in the surface of the photosensitive layer is shown in Fig. 7D and Fig. 7E. Fig. 7D and Fig. 7E shows a state in which a part of the perovskite components constituting the photosensitive layer 13B is replaced with the surface treating agent, and thus the compound layer is formed. In this case, a part of the compound layer may have the perovskite structure, as same as the photosensitive layer 13B. Fig. 7D shows a state in which the surface treating agent is present only on the surface of the photosensitive layer 13B, and Fig. 7E shows a state in which the surface treating agent is present to a certain depth from the surface of the photosensitive layer 13B.

For example, in a case of using the surface treating agent represented by $R-NH_3I$ (herein, R collectively represents groups containing a silyl group), the surface treating agent is incorporated in the perovskite structure as a component which is $R-NH_3^+$ in some cases.

In addition, in the state where the part of the perovskite components is replaced with the surface treating agent, in a case where the compound layer formed by the surface treating agent is sufficiently thin with respect to the photosensitive layer, the surface treating agent may not be exposed to an outermost layer of the compound layer as shown in Fig. 7F.

Although not illustrated, a case in which the part of the perovskite component is not replaced with the surface treating agent but the surface treating agent is merely mixed in the perovskite component, is also adopted as the second aspect.

(3) Third Aspect of Compound Layer

The third aspect of the compound layer is a combination of the first aspect and the second aspect.

In the present invention, the system 100 to which the photoelectric conversion element 10 is applied functions as a solar cell as follows.

Specifically, in the photoelectric conversion element 10, light that is transmitted through the conductive support 11, or the second electrode 2 and is incident to the photosensitive layer 13 excites a light absorbing agent. The excited light absorbing agent includes high-energy electrons and can emit the electrons. The light absorbing agent, which emits high-energy electrons, becomes an oxidized substance.

In the photoelectric conversion elements 10A to 10D and 10F, electrons emitted from the light absorbing agent migrate between a plurality of the light absorbing agents and reach the conductive support 11. The electrons which have reached the conductive support 11 work in the external circuit 6, and then return to the photosensitive layer 13 through the second electrode 2 (and also through the hole transport layer 3 in a case where the hole transport layer 3 is present). The light absorbing agent is reduced by the electrons which have returned to the photosensitive layer 13.

Meanwhile, in the photoelectric conversion element 10E, the electrons which have emitted from the light absorbing agent reaches the second electrode 2 from the photosensitive layer 13C through the electron transport layer 4, work in the external circuit 6, and then return to the photosensitive layer 13 through the conductive support 11. The light absorbing agent is reduced by the electrons which have returned to the photosensitive layer 13.

As described above, in the photoelectric conversion element 10, a cycle of excitation of the light absorbing agent and electron migration is repeated, and thus the system 100 functions as a solar cell.

In the photoelectric conversion elements 10A to 10D and 10F, a method of allowing an electron to flow from the photosensitive layer 13 to the conductive support 11 is different depending on presence or absence of the porous layer 12, a kind thereof, and the like. In the photoelectric conversion element 10 of the present invention, electron conduction, in which electrons migrate between the light absorbing agents, occurs. Accordingly, in a case where the porous layer 12 is provided, the porous layer 12 can be formed from an insulating substance other than semiconductors in the related art. In a case where the porous layer 12 is formed from a semiconductor, electron conduction, in which electrons migrate at the inside of semiconductor fine particles of the porous layer 12 or between the semiconductor fine particles, also occurs. On the other hand, in a case where the porous layer 12 is formed from an insulating substance, electron conduction in the porous layer 12 does not occur. In a case where the porous layer 12 is formed from the insulating substance, in a case of using fine particles of an aluminum oxide ($Al_2O_3$) as the fine particles of the insulating substance, a relatively high electromotive force (Voc) is obtained.

Even in a case where the blocking layer 14 as the other layer is formed from a conductor or a semiconductor,

electron conduction in the blocking layer 14 occurs.

In addition, even in the electron transport layer 15, electron conduction occurs.

The photoelectric conversion element and the solar cell of the present invention are not limited to the preferred aspects, and configurations and the like of the respective aspects may be appropriately combined between the respective aspects in a range not departing from the gist of the present invention. For example, as the configuration of the photoelectric conversion element 10C or 10D, the hole transport layer 3B may not be provided, as in the photoelectric conversion element 10F.

In the present invention, materials and respective members which are used in the photoelectric conversion element and the solar cell can be prepared by using a typical method except for materials and members which are defined in the present invention. In regard to the photoelectric conversion element using the perovskite compound as the light absorbing agent, or the solar cell, for example, Science 338, p. 643 to 647 (2012), J. Am. Chem. Soc., 2009, 131(17), p. 6050 to 6051, and Science, 338, p. 643 (2012) can be referred to.

In addition, reference can be made to materials and respective members which are used in a dye sensitized solar cell. With regard to dye sensitized solar cells, for example, reference can be made to JP2001-291534A, US4,927,721A, US4,684,537A, US5,084,365A, US5,350,644A, US5,463,057A, US5,525,440A, JP1995-249790A (JP-H7-249790A), JP2004-220974A, and JP2008-135197A.

Hereinafter, description will be given of preferred aspects of members and compounds which are suitably for being used in the photoelectric conversion element and the solar cell of the present invention.

<First Electrode 1>

The first electrode 1 includes the conductive support 11 and the photosensitive layer 13, and functions as an operation electrode in the photoelectric conversion element 10.

It is preferable that the first electrode 1 has at least one of the porous layer 12, the blocking layer 14, the electron transport layer 15, or the hole transport layer 16 as illustrated in Fig. 1A, and Fig. 2 to Fig. 6.

It is preferable that the first electrode 1 includes at least the blocking layer 14 from the viewpoint of short-circuit prevention, and more preferably the porous layer 12 and the blocking layer 14 from the viewpoints of light absorption efficiency and short-circuit prevention.

In addition, it is preferable that the first electrode 1 includes the electron transport layer 15 and the hole transport layer 16 which are formed from an organic material from the viewpoints of an improvement in productivity of the photoelectric conversion element, thickness reduction, and flexibilization.

- Conductive Support 11 -

The conductive support 11 is not particularly limited as long as the conductive support 11 has conductivity and can support the photosensitive layer 13 and the like. It is preferable that the conductive support 11 has a configuration formed from a conductive material, for example, a metal, or a configuration including the support 11a formed from glass or plastic and the transparent electrode 11b formed on a surface of the support 11a as a conductive film.

Among these, as illustrated in Fig. 1A, and Fig. 2 to Fig. 6, it is more preferable that the conductive support 11 has a configuration in which a conductive metal oxide is applied to the surface of the support 11a formed from glass or plastic to form the transparent electrode 11b. Examples of the support 11a formed from plastic include a transparent polymer film described in Paragraph 0153 of JP2001-291534A. As a material that forms the support 11a, it is possible to use ceramic (JP2005-135902A) and a conductive resin (JP2001-160425A) in addition to glass or plastic. As a metal oxide, a tin oxide (TO) is preferable, and an indium-tin oxide (a tin-doped indium oxide; ITO) or a tin oxide doped with fluorine such as a fluorine-doped tin oxide (FTO) is more preferable. At this time, the amount of the metal oxide applied is preferably 0.1 to 100 g per 1 $m^2$ of a surface area of the support 11a. In a case of using the conductive support 11, it is preferable that light is incident from a support 11a side.

It is preferable that the conductive support 11 is substantially transparent. In the present invention, "substantially transparent" represents that transmittance of light (having a wavelength of 300 to 1200 nm) is 10% or greater, preferably 50% or greater, and more preferably 80% or greater.

The thickness of the support 11a and the conductive support 11 is not particularly limited and is set to an appropriate thickness. For example, the thickness is preferably 0.01 μm to 10 mm, more preferably 0.1 μm to 5 mm, and still preferably 0.3 μm to 4 mm.

In a case of providing the transparent electrode 11b, the film thickness of the transparent electrode 11b is not particularly limited. For example, the film thickness is preferably 0.01 to 30 μm, more preferably 0.03 to 25 μm, and still more preferably 0.05 to 20 μm.

The conductive support 11 or the support 11a may have a light management function on the surface. For example, the conductive support 11 or the support 11a may include an antireflection film formed by alternately laminating

a high-refractive-index film and a low-refractive-index oxide film on the surface of the conductive support 11 or the support 11a as described in JP2003-123859A or may have a light guide function as described in JP2002-260746A.

- Blocking Layer 14 -

In the present invention, as in the photoelectric conversion elements 10A to 10C and 10F, the blocking layer 14 is preferably provided on the surface of the transparent electrode 11b, that is, between the conductive support 11, and the porous layer 12, the photosensitive layer 13, the hole transport layer 3, or the like.

In the photoelectric conversion element and the solar cell, for example, in a case where the photosensitive layer 13 or the hole transport layer 3, and the transparent electrode 11b are electrically connected to each other, a reverse current is generated. The blocking layer 14 plays a role of preventing the reverse current. The blocking layer 14 is also referred to as a "short-circuit prevention layer".

The blocking layer 14 may be allowed to function as a stage that carries the light absorbing agent.

The blocking layer 14 may be provided even in a case where the photoelectric conversion element includes the electron transport layer. For example, in a case of the photoelectric conversion element 10D, the blocking layer 14 may be provided between the conductive support 11 and the electron transport layer 15, and in a case of the photoelectric conversion element 10E, the blocking layer 14 may be provided between the second electrode 2 and the electron transport layer 4.

The material that forms the blocking layer 14 is not particularly limited as long as the material can perform the above-described function, and it is preferable that the material is a material through which visible light is transmitted, and which has insulating properties with respect to the conductive support 11 (transparent electrode 11b). Specifically, "material having insulating properties with respect to the conductive support 11 (transparent electrode 11b)" represents a compound (n-type semiconductor compound) having a conduction band energy level that is equal to or higher than a conduction band energy level of a material that forms the conductive support 11 (a metal oxide that forms the transparent electrode 11b) and is lower than a conduction band energy level of a material that constitutes the porous layer 12 or a ground state energy level of the light absorbing agent.

Examples of a material that forms the blocking layer 14 include silicon oxide, magnesium oxide, aluminum oxide, calcium carbonate, cesium carbonate, polyvinyl alcohol, polyurethane, and the like. In addition, the material may be a material that is typically used as a photoelectric conversion material, and examples thereof include titanium oxide, tin oxide, zinc oxide, niobium oxide, tungsten oxide, and the like. Among these, titanium oxide, tin oxide, magnesium oxide, aluminum oxide, and the like are preferred.

It is preferable that the film thickness of the blocking layer 14 is 0.001 to 10 $\mu$m, more preferably 0.005 to 1 $\mu$m, and still more preferably 0.01 to 0.1 $\mu$m.

In the present invention, the film thicknesses of the respective layers can be measured by observing a cross-section of the photoelectric conversion element 10 by using a scanning electron microscope (SEM) and the like.

- Porous Layer 12 -

In the present invention, as in the photoelectric conversion elements 10A, 10B, and 10F, the porous layer 12 is preferably provided on the transparent electrode 11b. In a case where the blocking layer 14 is provided, the porous layer 12 is preferably formed on the blocking layer 14.

The porous layer 12 is a layer that functions as a stage that carries the photosensitive layer 13 on the surface. In the photoelectric conversion element, so as to increase the light absorption efficiency, it is preferable to increase a surface area of at least a portion that receives light such as photoelectric conversion element, and it is preferable to increase the surface area of the porous layer 12 as a whole.

It is preferable that the porous layer 12 is a fine particle layer that includes pores and is formed through deposition or close contact of fine particles of a material that forms the porous layer 12. The porous layer 12 may be a fine particle layer that is formed through deposition of two or more kinds of fine particles. In a case where the porous layer 12 is a fine particle layer that includes pores, it is possible to increase the amount (adsorption amount) of the carried light absorbing agent.

It is preferable to increase the surface area of individual fine particles which constitute the porous layer 12 so as to increase the surface area of the porous layer 12. In the present invention, in a state in which the fine particles are applied to the conductive support 11 and the like, it is preferable that the surface area of the fine particles which form the porous layer 12 is 10 or more times a projected area, and more preferably 100 or more times the projected area. The upper limit thereof is not particularly limited. Typically, the upper limit is approximately 5000 times the projected area. With regard to a particle size of the fine particles which form the porous layer 12, an average particle size, which uses a diameter when converting the projected area into a circle, is preferably 0.001 to 1 $\mu$m as primary particles. In a case where the porous layer 12 is formed by using a dispersion of fine particles, the average particle size of the fine

particles is preferably 0.01 to 100 μm in terms of an average particle size of the dispersion.

For the material that forms the porous layer 12, there is no particular limitation with respect to conductivity. The material may be an insulating substance (insulating material), a conductive material, or a semiconductor (semi-conductive material).

As the material that forms the porous layer 12, it is possible to use, for example, chalcogenides (for example, an oxide, a sulfide, a selenide, and the like) of metals, compounds having a perovskite-type crystal structure (excluding a perovskite compound that uses a light absorbing agent), oxides of silicon (for example, silicon dioxide, and zeolite), or carbon nanotubes (including carbon nanowires, carbon nanorods, and the like).

The chalcogenides of a metal are not particularly limited, and preferred examples thereof include respective oxides of titanium, tin, zinc, tungsten, zirconium, hafnium, strontium, indium, cerium, yttrium, lanthanum, vanadium, niobium, aluminum, and tantalum, cadmium sulfide, cadmium selenide, and the like. Examples of the crystal structure of the chalcogenides of metals include an anatase-type crystal structure, a brookite-type crystal structure, and a rutile-type crystal structure, and the anatase-type crystal structure and the brookite-type crystal structure are preferable.

The compound having a perovskite-type crystal structure is not particularly limited, and examples thereof include a transition metal oxide and the like. Examples of the transition metal oxide include strontium titanate, calcium titanate, barium titanate, zinc titanate, barium zirconate, barium stannate, zinc zirconate, strontium zirconate, strontium tantalate, potassium niobate, bismuth ferrate, barium strontium titanate, lanthanum barium titanate, calcium titanate, sodium titanate, and bismuth titanate. Among these, strontium titanate, calcium titanate, and the like are preferable.

The carbon nanotubes have a shape obtained by rounding off a carbon film (graphene sheet) into a tubular shape. The carbon nanotubes are classified into a single-walled carbon nanotube (SWCNT) obtained by winding one graphene sheet in a cylindrical shape, a double-walled carbon nanotube (DWCNT) obtained by winding two graphene sheets in a concentric shape, and a multi-walled carbon nanotube (MWCNT) obtained by winding a plurality of graphene sheets in a concentric shape. As the porous layer 12, any carbon nanotubes can be used without any particular limitation.

Among these, as the material that forms the porous layer 12, an oxide of titanium, tin, zinc, zirconium, aluminum, or silicon, or a carbon nanotube is preferable, and titanium oxide or aluminum oxide is more preferable.

The porous layer 12 may be formed from at least one kind of the chalcogenides of metals, the compound having a perovskite-type crystal structure, the oxide of silicon, or the carbon nanotube, or may be formed from a plurality of kinds thereof.

The film thickness of the porous layer 12 is not particularly limited. The thickness is typically in a range of 0.05 to 100 μm, and preferably in a range of 0.1 to 100 μm. In a case of being used as a solar cell, the film thickness is preferably 0.1 to 50 μm, more preferably 0.2 to 30 μm, and even more preferably 0.3 to 30 μm.

- Electron Transport Layer 15 -

In the present invention, as in the photoelectric conversion element 10D, the electron transport layer 15 may be provided on the surface of the transparent electrode 11b.

The electron transport layer 15 has a function of transporting electrons, which are generated in the photosensitive layer 13, to the conductive support 11. The electron transport layer 15 is formed from an electron transporting material capable of exhibiting the above-described function. The electron transporting material is not particularly limited, and an organic material (organic electron transporting material) is preferable. Examples of the organic electron transporting material include fullerene compounds such as [6,6]-phenyl-C61-butyric acid methyl ester ($PC_{61}BM$), perylene compounds such as perylene tetracarboxylic diimide (PTCDI), low-molecular-weight compounds such as tetracyanoquinodimethane (TCNQ), high-molecular-weight compounds, and the like.

Although not particularly limited, it is preferable that the film thickness of the electron transport layer 15 is 0.001 to 10 μm, and more preferably 0.01 to 1 μm.

- Hole Transport Layer 16 -

In the present invention, as in the photoelectric conversion element 10E, the hole transport layer 16 may be provided on the surface of the transparent electrode 11b.

The hole transport layer 16 is the same as the hole transport layer 3 to be described later except for a different formation position.

- Photosensitive layer (Light Absorbing Layer) 13 -

The photosensitive layer 13 is preferably provided on the surface (including an inner surface of a concave portion in a case where a surface on which the photosensitive layer 13 is provided is uneven) of each of the porous layer 12 (in the photoelectric conversion elements 10A, 10B, and 10F), the blocking layer 14 (in the photoelectric conversion

element 10C), the electron transport layer 15 (in the photoelectric conversion element 10D), and the hole transport layer 16 (in the photoelectric conversion element 10E).

In the present invention, the light absorbing agent may contain at least one specific kind of perovskite compound to be described later, or may contain two or more kinds of perovskite compounds. In addition, the light absorbing agent may include a light absorbing agent other than the perovskite compound in combination with the perovskite compound. Examples of the light absorbing agent other than the perovskite compound include a metal complex dye, and an organic dye. At this time, a ratio between the perovskite compound and the light absorbing agent other than the perovskite compound is not particularly limited.

The photosensitive layer 13 may be a monolayer or a laminated layer of two or more layers. In a case where the photosensitive layer 13 has the laminated layer structure of two or more layers, the laminated layer structure may be a laminated layer structure obtained by laminating layers formed from light absorbing agents different from each other, or a laminated layer structure including an interlayer including a hole transporting material between a photosensitive layer and a photosensitive layer.

The aspect in which the photosensitive layer 13 is provided on the conductive support 11 is as described above. The photosensitive layer 13 is preferably provided on a surface of each of the layers in order for an excited electron to flow to the conductive support 11 or the second electrode 2. At this time, the photosensitive layer 13 may be provided on the entirety or a part of the surface of each of the layers.

The photosensitive layer 13 has a compound represented by any one of Formulas (A-0), (A-1), and (A-2), on the surface of the layer. The aspect in which the compound is present on the surface of the layer is as described above.

The film thickness of the photosensitive layer 13 is appropriately set in correspondence with an aspect in which the photosensitive layer 13 is provided on the conductive support 11, and is not particularly limited. For example, the film thickness is preferably 0.001 to 100 μm, more preferably 0.01 to 10 μm, and still more preferably 0.01 to 5 μm.

In a case where the porous layer 12 is provided, a total film thickness including the film thickness of the porous layer 12 is preferably 0.01 μm or greater, more preferably 0.05 μm or greater, still more preferably 0.1 μm or greater, and still more preferably 0.3 μm or greater. In addition, the total film thickness is preferably 100 μm or less, more preferably 50 μm or less, and still more preferably 30 μm or less. The total film thickness may be set to a range in which the above-described values are appropriately combined. Here, as illustrated in Fig. 1A, in a case where the photosensitive layer 13 has a thin film shape, the film thickness of the photosensitive layer 13 represents a distance between an interface with the porous layer 12, and an interface with the hole transport layer 3 to be described later along a direction that is perpendicular to the surface of the porous layer 12.

In the photoelectric conversion element 10, a total film thickness of the porous layer 12, the photosensitive layer 13, the compound layer 5, and the hole transport layer 3 is not particularly limited. For example, the total thickness is preferably 0.01 μm or greater, more preferably 0.05 μm or greater, still more preferably 0.1 μm or greater, and still more preferably 0.5 μm or greater. In addition, the total film thickness is preferably 200 μm or less, more preferably 50 μm or less, still more preferably 30 μm or less, and still more preferably 5 μm or less. The total film thickness may be set to a range in which the above-described values are appropriately combined.

In the present invention, in a case where the photosensitive layer is provided in a thick film shape (in the photosensitive layer 13B and 13C), the light absorbing agent that is included in the photosensitive layer may function as a hole transporting material.

The amount of the perovskite compound used may be set to an amount capable of covering at least a part of a surface of the first electrode 1, and preferably an amount capable of covering the entirety of the surface.

[Light Absorbing Agent of Photosensitive Layer]

The photosensitive layer 13 contains at least one kind of perovskite compound (also referred to as perovskite-type light absorbing agent) having "an element of Group 1 in the periodic table or a cationic organic group A", a metal atom M other than elements of Group 1 in the periodic table", and "an anionic atom or atomic group X" as the light absorbing agent.

In the perovskite compound, the element of Group 1 in the periodic table or the cationic organic group A, the metal atom M, and the anionic atom or atomic group X exists as individual constituent ions of a cation (for convenience, may be referred to as "A cation"), a metal cation (for convenience, may be referred to as "M cation"), and an anion (for convenience, may be referred to as "X anion") in the perovskite-type crystal structure.

In the present invention, the cationic organic group represents an organic group having a property of becoming a cation in the perovskite-type crystal structure, and the anionic atom or atomic group represents an atom or atomic group that has a property of becoming an anion in the perovskite-type crystal structure.

In the perovskite compound that is used in the present invention, the A cation represents a cation of an element of Group 1 in the periodic table or an organic cation that is composed of a cationic organic group A. The A cation is preferably an organic cation.

The cation of an element of Group 1 in the periodic table is not particularly limited, and examples thereof include cations ($Li^+$, $Na^+$, $K^+$, and $Cs^+$) of individual elements of lithium (Li), sodium (Na), potassium (K), and cesium (Cs), and the cation ($Cs^+$) of cesium is more preferable.

The organic cation is not particularly limited as long as the organic cation is a cation of an organic group having the above-described property, but an organic cation of a cationic organic group represented by the following Formula (1) is more preferable.

Formula (1): $R^{1a}-NH_3^+$

In Formula (1), $R^{1a}$ represents a substituent. $R^{1a}$ is not particularly limited as long as $R^{1a}$ is an organic group, but an alkyl group, a cycloalkyl group, an alkenyl group, an alkynyl group, an aryl group, a heteroaryl group, or a group represented by Formula (2) is preferable. Among these, the alkyl group and a group represented by the following Formula (2) are more preferable.

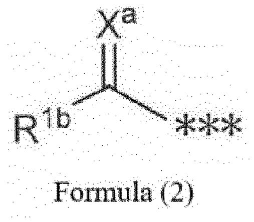

Formula (2)

In Formula (2), $X^a$ represents $NR^{1c}$, an oxygen atom, or a sulfur atom. $R^{1b}$ and $R^{1c}$ each independently represent a hydrogen atom or a substituent. *** represents a binding site with a nitrogen atom in Formula (1).

In the present invention, as the organic cation of the cationic organic group A, an organic ammonium cation ($R^{1a}-NH_3^+$) composed of an ammonium cationic organic group A obtained through bonding between $R^{1a}$ and $NH_3$ in Formula (1) is preferable. In a case where the organic ammonium cation can employ a resonance structure, the organic cation further includes a cation having the resonance structure in addition to the organic ammonium cation. For example, in a case where $X^a$ is NH ($R^{1c}$ is a hydrogen atom) in a group represented by Formula (2), the organic cation also includes an organic amidinium cation that is one of a resonance structure of the organic ammonium cation in addition to the organic ammonium cation of the ammonium cationic organic group obtained through bonding between the group represented by Formula (2) and $NH_3$. Examples of the organic amidinium cation composed of the amidinium cationic organic group include a cation represented by the following Formula ($A^{am}$). In this specification, the cation represented by the following Formula ($A^{am}$) may be noted as "$R^{1b}C(=NH)-NH_3^+$" for convenience.

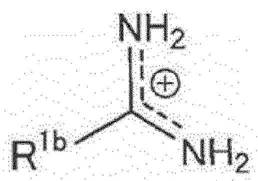

Formula ($A^{am}$)

The alkyl group is preferably an alkyl group having 1 to 18 carbon atoms, more preferably an alkyl group having 1 to 6 carbon atoms, and still more preferably an alkyl group having 1 to 3 carbon atoms. Examples of the alkyl group include methyl, ethyl, propyl, isopropyl, butyl, tert-butyl, pentyl, hexyl, decyl, and the like.

The cycloalkyl group is preferably a cycloalkyl group having 3 to 8 carbon atoms, and examples thereof include cyclopropyl, cyclopentyl, cyclohexyl, and the like.

The alkenyl group is preferably an alkenyl group having 2 to 18 carbon atoms, and more preferably an alkenyl group having 2 to 6 carbon atoms. Examples of the alkenyl group include vinyl, allyl, butenyl, hexenyl, and the like.

The alkynyl group is preferably an alkynyl group having 2 to 18 carbon atoms, and more preferably an alkynyl group having 2 to 4 carbon atoms. Examples of the alkynyl group include ethynyl, butynyl, hexynyl, and the like.

The aryl group is preferably an aryl group having 6 to 14 carbon atoms, more preferably an aryl group having 6 to 12 carbon atoms, and examples thereof include phenyl.

The heteroaryl group includes a group composed of an aromatic hetero ring alone, and a group composed of a fused hetero ring obtained through condensing of another ring, for example, an aromatic ring, an aliphatic ring, or a

hetero ring with the aromatic hetero ring.

As the ring-constituting hetero atom that constitutes the aromatic hetero ring, a nitrogen atom, an oxygen atom, or a sulfur atom is preferable. In addition, with regard to the number of ring members of the aromatic hetero ring, a 3- to 8-membered ring is preferable, and a 5- or 6-membered ring is more preferable. The number of carbon atoms of the aromatic hetero ring is preferably 0 to 20, and more preferably 1 to 18.

Examples of the 5-membered aromatic hetero ring and the fused hetero ring including the 5-membered aromatic hetero ring include respective cyclic groups of a pyrrole ring, an imidazole ring, a pyrazole ring, an oxazole ring, a thiazole ring, a triazole ring, a furan ring, a thiophene ring, a benzimidazole ring, a benzoxazole ring, a benzothiazole ring, an indoline ring, and an indazole ring. In addition, examples of the 6-membered aromatic hetero ring and the fused hetero ring including the 6-membered aromatic hetero ring include respective cyclic groups of a pyridine ring, a pyrimidine ring, a pyrazine ring, a triazine ring, a quinoline ring, and a quinazoline ring.

In the group represented by Formula (2), $X^a$ represents $NR^{1c}$, an oxygen atom, or a sulfur atom, and $NR^{1c}$ is preferable as $X^a$. Here, $R^{1c}$ represents a hydrogen atom or a substituent. $R^{1c}$ is preferably a hydrogen atom, an alkyl group, a cycloalkyl group, an alkenyl group, an alkynyl group, an aryl group, or a heteroaryl group, and more preferably a hydrogen atom.

$R^{1b}$ represents a hydrogen atom or a substituent, and is preferably a hydrogen atom. Examples of the substituent that can be employed as $R^{1b}$ include an amino group, an alkyl group, a cycloalkyl group, an alkenyl group, an alkynyl group, an aryl group, a heteroaryl group.

An alkyl group, a cycloalkyl group, an alkenyl group, an alkynyl group, an aryl group, and a heteroaryl group that can be respectively employed as $R^{1b}$ and $R^{1c}$ are the same as the respective groups of $R^{1a}$, and preferred examples thereof are the same as described above.

Examples of the group represented by Formula (2) include a (thio)acyl group, a (thio)carbamoyl group, an imidoyl group, and an amidino group.

Examples of the (thio)acyl group include an acyl group and a thioacyl group. The acyl group is preferably an acyl group having a total of 1 to 7 carbon atoms, and examples thereof include formyl, acetyl (r-34), propionyl, hexanoyl, and the like. The thioacyl group is preferably a thioacyl group having a total of 1 to 7 carbon atoms, and examples thereof include thioformyl, thioacetyl (r-36), thiopropionyl, and the like.

Examples of the (thio)carbamoyl group include a carbamoyl group (r-35) and a thiocarbamoyl group ($H_2NC(=S)$-).

The imidoyl group is a group represented by $R^{1b}$-C(=$NR^{1c}$)-, and it is preferable that $R^{1b}$ and $R^{1c}$ are respectively a hydrogen atom and an alkyl group. More preferably, the alkyl group is the same as the alkyl group as $R^{1a}$. Examples thereof include formimidoyl (r-37), acetoimidoyl (r-39), propionimidoyl ($CH_3CH_2C(=NH)$-), and the like. Among these, formimidoyl is preferable.

The amidino group as the group represented by Formula (2) has a structure (r-38) in which $R^{1b}$ of the imidoyl group is an amino group and $R^{1c}$ is a hydrogen atom.

The entirety of the alkyl group, the cycloalkyl group, the alkenyl group, the alkynyl group, the aryl group, the heteroaryl group, and the group represented by Formula (2), which can be employed as $R^{1a}$, may have a substituent. The substituent $W^P$, which $R^{1a}$ may have, is not particularly limited, and examples thereof include an alkyl group, a cycloalkyl group, an alkenyl group, an alkynyl group, an aryl group, a heterocyclic group, an alkoxy group, an alkylthio group, an amino group, an alkylamino group, an arylamino group, an acyl group, an alkoxycarbonyl group, an aryloxycarbonyl group, an acylamino group, a sulfonamide group, a carbamoyl group, a sulfamoyl group, a halogen atom, a silyl group, a cyano group, a hydroxy group, a mercapto group, and a carboxy group. The substituent, which $R^{1a}$ may have, may be additionally substituted with a substituent.

As specific examples of $R^{1a}$ of Formula (1), r-1 to r-39 are shown below, but the present invention is not limited thereto. In the following specific examples, "*" represents a binding site with a nitrogen atom, "Me" represents a methyl group, and "Et" represents an ethyl group.

r-1 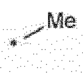 r-10 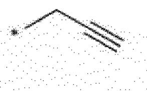 r-18 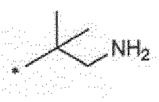

r-2 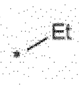 r-11 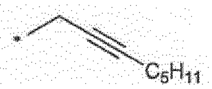

r-3 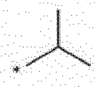

r-12 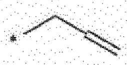

r-19 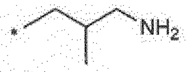

r-4 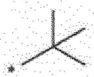

r-13 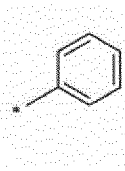

r-20 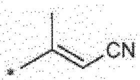

r-5 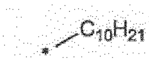

r-14 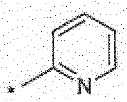

r-21 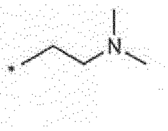

r-6 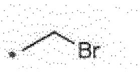

r-22 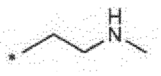

r-7 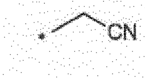

r-15 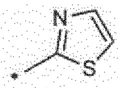

r-23 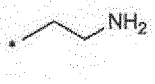

r-8 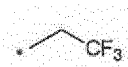

r-16 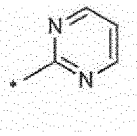

r-24 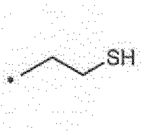

r-9 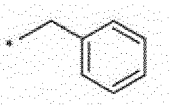

r-17 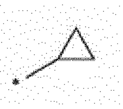

r-25 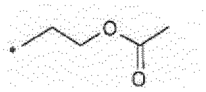

r-28 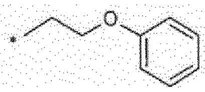

r-31 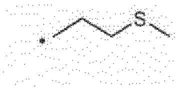

r-26 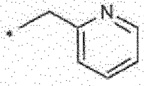

r-29 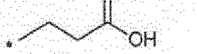

r-32 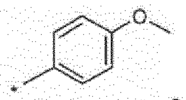

r-27 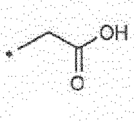

r-30 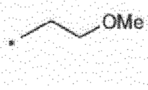

r-33 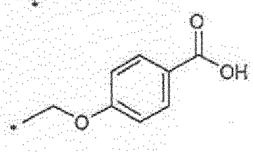

r−34 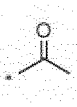

r−35 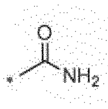

r−36 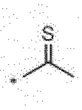

r-37 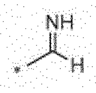 r-38 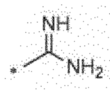 r-39 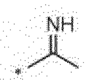

In the perovskite compound that is used in the present invention, the M cation is not particularly limited as long as the metal cation M is a cation of a metal atom other than elements of Group 1 in the periodic table and is a cation of a metal atom that can employ the perovskite-type crystal structure. Examples of the metal atom include metal atoms such as calcium (Ca), strontium (Sr), cadmium (Cd), copper (Cu), nickel (Ni), manganese (Mn), iron (Fe), cobalt (Co), palladium (Pd), germanium (Ge), tin (Sn), lead (Pb), ytterbium (Yb), europium (Eu), indium (In), and the like. Among these, as the metal atom M, a Pb atom or a Sn atom is more preferable. M may be one kind of metal atom, or two or more kinds of metal atoms. In a case where M includes two or more kinds of metal atoms, two kinds including the Pb atom and the Sn atom are preferable. A ratio of the metal atoms at this time is not particularly limited.

In the perovskite compound that is used in the present invention, the X anion represents an anion of an anionic atom or atomic group X. Preferred examples of the anion include anions of halogen atoms, and anions of individual atomic groups of $NCS^-$, $NCO^-$, $CH_3COO^-$, and $HCOO^-$. Among these, the anions of halogen atoms are more preferable. Examples of the halogen atoms include a fluorine atom, a chlorine atom, a bromine atom, an iodine atom, and the like.

The X anion may be an anion of one kind of anionic atom or atomic group, or anions of two or more kinds of anionic atoms or atomic groups. In a case where the anion X is an anion of one kind of anionic atom or atomic group, an anion of an iodine atom is preferable. On the other hand, in a case where the anion X includes anions of two or more kinds of anionic atoms or atomic groups, anions of two kinds of halogen atoms, particularly, an anion of a chlorine atom and an anion of an iodine atom are preferable. A ratio between two or more kinds of anions is not particularly limited.

As the perovskite compound that is used in the present invention, a perovskite compound, which has a perovskite-type crystal structure including the above-described constituent ions and is represented by the following Formula (I), is preferable.

Formula (I): $A_aM_mX_x$

In Formula (I), A represents an element of Group 1 in the periodic table or a cationic organic group. M represents a metal atom other than elements of Group 1 in the periodic table. X represents an anionic atom or atomic group. a represents 1 or 2, m represents 1, and a, m, and x satisfy a relationship of $a+2m = x$.

In Formula (I), the element of Group 1 in the periodic table or the cationic organic group A forms the A cation of the perovskite-type crystal structure. Accordingly, there is no particular limitation as long as the element of Group 1 in the periodic table and the cationic organic group A are elements or groups which become the A cation and can constitute the perovskite-type crystal structure. The element of Group 1 in the periodic table or the cationic organic group A is the same as the element of Group 1 in the periodic table or the cationic organic group which is described in the A cation, and preferred examples thereof are the same as described above.

The metal atom M is a metal atom that forms the M cation of the perovskite-type crystal structure. Accordingly, the metal atom M is not particularly limited as long as the metal atom M is an atom other than elements of Group 1 in the periodic table, becomes the M cation, and constitutes the perovskite-type crystal structure. The metal atom M is the same as the metal atom that is described in the M cation, and preferred examples thereof are the same as described above.

The anionic atom or atomic group X forms the X anion of the perovskite-type crystal structure. Accordingly, the anionic atom or atomic group X is not particularly limited as long as the anionic atom or atomic group X is an atom or atomic group that becomes the X anion and can constitute the perovskite-type crystal structure. The anionic atom or atomic group X is the same as the anionic atom or atomic group which is described in the X anion, and preferred examples thereof are the same as described above.

The perovskite compound represented by Formula (I) is a perovskite compound represented by the following Formula (1-1) in a case where a is 1, or a perovskite compound represented by the following Formula (1-2) in a case where a is 2.

Formula (I-1): $AMX_3$

Formula (1-2): $A_2MX_4$

In Formula (1-1) and Formula (1-2), A represents an element of Group 1 in the periodic table or a cationic organic group. A is the same as A in Formula (I), and preferred examples thereof are the same as described above.

M represents a metal atom other than elements of Group 1 in the periodic table. M is the same as M in Formula (I), and preferred examples thereof are the same as described above.

X represents an anionic atom or atomic group. X is the same as X in Formula (I), and preferred examples thereof are the same as described above.

The perovskite compound that is used in the present invention may be any one of the compound represented by Formula (1-1) and the compound represented by Formula (1-2), or a mixture thereof. Accordingly, in the present invention, at least one kind of the perovskite compound may exist as the light absorbing agent, and there is no need for clear and strict distinction on that the perovskite compound is which compound by using a composition formula, a molecular formula, a crystal structure, and the like.

Hereinafter, specific examples of the perovskite compound that can be used in the present invention will be exemplified, but the present invention is not limited to the specific examples. In the following description, the perovskite compound is classified into the compound represented by Formula (1-1) and the compound represented by Formula (1-2). However, even the compound exemplified as the compound represented by Formula (1-1) may be the compound represented by Formula (1-2) in accordance with synthesis conditions, or may be a mixture of the compound represented by Formula (1-1) and the compound represented by Formula (1-2). Similarly, even the compound exemplified as the compound represented by Formula (1-2) may be the compound represented by Formula (I-1), or may be a mixture of the compound represented by Formula (1-1) and the compound represented by Formula (1-2).

Specific examples of the compound represented by Formula (1-1) include $CH_3NH_3PbCl_3$, $CH_3NH_3PbBr_3$, $CH_3NH_3PbI_3$, $CH_3NH_3PbBrI_2$, $CH_3NH_3PbBr_2I$, $CH_3NH_3SnBr_3$, $CH_3NH_3SnI_3$, and $CH(=NH)NH_3PbI_3$.

Specific examples of the compound represented by Formula (1-2) include $(C_2H_5NH_3)_2PbI_4$, $(CH_2=CHNH_3)_2PbI_4$, $(CH\equiv CNH_3)_2PbI_4$, $(n\text{-}C_3H_7NH_3)_2PbI_4$, $(n\text{-}C_4H_9NH_3)_2PbI_4$, $(C_{10}H_{21}NH_3)_2PbI_4$, $(C_6H_5NH_3)_2PbI_4$, $(C_6H_5CH_2CH_2NH_3)_2PbI_4$, $(C_6H_3F_2NH_3)_2PbI_4$, $(C_6F_5NH_3)_2PbI_4$, $(C_4H_3SNH_3)_2PbI_4$. Here, $C_4H_3SNH_3$ in $(C_4H_3SNH_3)_2PbI_4$ represents aminothiophene.

The perovskite compound can be synthesized from a compound represented by the following Formula (II) and a compound represented by the following Formula (III).

Formula (II): AX

Formula (III): $MX_2$

In Formula (II), A represents an element of Group 1 in the periodic table, or a cationic organic group. A is the same as A in Formula (I), and preferred examples thereof are the same as described above. In Formula (II), X represents an anionic atom or atomic group. X is the same as X in Formula (I), and preferred examples thereof are the same as described above.

In Formula (III), M represents a metal atom other than elements of Group 1 in the periodic table. M is the same as M in Formula (I), and preferred examples thereof are the same as described above. In Formula (III), X represents an anionic atom or atomic group. X is the same as X in Formula (I), and preferred examples thereof are the same as described above.

Examples of a method for synthesizing the perovskite compound include the method described in Science 338, p. 643 to 647 (2012). Examples thereof include methods which are described in Akihiro Kojima, Kenjiro Teshima, Yasuo Shirai, and Tsutomu Miyasaka, "Organometal Halide Perovskites as Visible-Light Sensitizers for Photovoltaic Cells", J. Am. Chem. Soc., 2009, 131(17), p. 6050 to 6051.

The amount of the light absorbing agent used is preferably set to an amount capable of covering at least a part of the surface of layers provided to be adjacent to each other, and more preferably an amount capable of covering the entirety of the surface.

The amount of the perovskite compound contained in the photosensitive layer 13 is typically 1% to 100% by mass.

- Compound Layer 5 -

In the present invention, the compound layer containing the surface treating agent having a silyl group is provided on the surface of the photosensitive layer of the first electrode. The aspect and the state of the compound layer provided on the surface of the photosensitive layer of the first electrode are as described above. In the photoelectric conversion element of the present invention, the hole transport layer 3, the electron transport layer 4, or the second electrode 2 is preferably provided on the first electrode 1. In this case, the compound layer 5 is sandwiched between the surface of the photosensitive layer of the first electrode 1, and the hole transport layer 3, the electron transport layer 4, or the second electrode 2.

The compound layer may be present on the surface of the photosensitive layer of the first electrode. Whether the compound layer is present on the surface of the photosensitive layer of the first electrode can be confirmed as below. That is, a sufficient area of the surface of the photosensitive layer of the first electrode is washed with an organic solvent or water that can dissolve the compound layer. A filtrate obtained by filtering the obtained washing solution is concentrated

and purified as necessary, and is analyzed by gel permeation chromatography (GPC), high performance liquid chromatography (HPLC), or nuclear magnetic resonance (NMR). According to the analysis, the presence or absence of the surface treating agent on the surface of the first electrode can be confirmed, or an abundance thereof can be quantitatively determined. The surface treating agent referred herein also includes components of the surface treating agent in the form of being incorporated in the perovskite structure as described above.

The abundance of the surface treating agent present on the surface is not particularly limited as long as the effect of the present invention is exhibited. The abundance of the surface treating agent present on the surface of the photosensitive layer of the first electrode can vary according to a concentration of a liquid containing the surface treating agent, a surface area to which the surface treating agent comes into contact with, or the like. Examples of the abundance of the surface treating agent include a range of 0.1 $mg/m^2$ to 100 $g/m^2$, and a range of 1 $mg/m^2$ to 1 $g/m^2$. The abundance of the surface treating agent is not limited to the above ranges, and even in a case where the abundance of the surface treating agent is 0.1 $mg/m^2$ or less, the effect of the present invention can be obtained.

In the present invention, from the viewpoint of realizing an improvement in photoelectric conversion characteristics and stability of the battery performance, and the like, it is preferable that the surface treating agent uniformly covers the surface of the photosensitive layer of the first electrode, and molecules of the surface treating agent are not overlapped each other (a form of a monolayer).

The form of the presence and the abundance of the surface treating agent are achieved by allowing the liquid contacting the surface treating agent to come into contact with the surface of the photosensitive layer of the first electrode, and preferably achieved by allowing the liquid to come into contact with an entire surface of the photosensitive layer of the first electrode.

A reason why the moisture resistance variation between the elements can be reduced in the photoelectric conversion element in which the compound layer containing the surface treating agent having the silyl group is provided on the surface of the photosensitive layer of the first electrode, is not clear, but the reason is presumed as follows.

In the photoelectric conversion element, the perovskite compound is decomposed by penetration of water from a defect at an interface of materials and the moisture contained in the hole transporting material. It is considered that it is difficult to control the penetration and inclusion of the moisture in the element of the related art, and therefore the moisture resistance variation occurs between the photoelectric conversion elements. It is presumed that the surface treating agent contained in the compound layer used in the present invention has an effect of enhancing the adhesion with the adjacent layer (hole transport layer, second electrode, and the like) in addition to an effect of making the photosensitive layer hydrophobic, and thus the moisture resistance variation of the photoelectric conversion element is improved.

The compound layer may contain at least one kind of surface treating agent having a silyl group, or may contain a plurality of kinds of surface treating agents. In addition to the above usage, the surface treating agent having a silyl group may be used as the composition for surface treatment containing an additive. Examples of the additive include a compound selected from the group consisting of a halide having an element of Group 1 in the periodic table and a halide having a cationic organic group A. Examples of the cationic organic group A include a cationic organic group represented by Formula (1) described above. In addition, $R^{1a}$ of the cationic organic group represented by Formula (1) is preferably the group represented by Formula (2) described above.

Hereinafter, the preferable surface treating agent used in the present invention will be described.

Examples of the preferable surface treating agent include the compound represented by Formula (A-0).

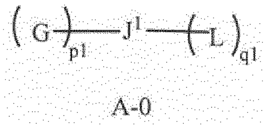

A-0

In Formula (A-0), G represents a group or a salt selected from the group consisting of $-OR^a$, $-O^-Ya^+$, $-SR^a$, $-S^-Ya^+$, $-NR^aR^b$, $-(NR^aR^bR^c)^+Ya^-$, $-COOR^a$, $-COO^-Ya^+$, $-SO_3R^a$, $-SO_3^-Ya^+$, $-P(=O)(OR^a)_2$, $-P(=O)(O^-Ya^+)_2$, $-B(OR^a)_2$, and $-B(OR^a)_3^-Ya^+$. $R^a$, $R^b$, and $R^c$ each independently represent a hydrogen atom or a substituent. Ya represents a counter salt. p1 represents an integer of 1 or more. L represents a silyl group. q1 represents an integer of 1 or more. $J^1$ represents a single bond or a linking group.

The compound represented by Formula (A-0) will be described.

G represents a group or a salt selected from the group consisting of $-OR^a$, $-O^-Ya^+$, $-SR^a$, $-S^-Ya^+$, $-NR^aR^b$, $-(NR^aR^bR^c)^+Ya^-$, $-COOR^a$, $-COO^-Ya^+$, $-SO_3R^a$, $-SO_3^-Ya^+$, $-P(=O)(OR^a)_2$, $-P(=O)(O^-Ya^+)_2$, $-B(OR^a)_2$, and $-B(OR^a)_3^-Ya^+$.

$R^a$, $R^b$, and $R^c$ each independently represent a hydrogen atom or a substituent. In a case where $R^a$, $R^b$, and $R^c$ represent a substituent, the substituent is not particularly limited, and examples thereof include the substituent $W^P$ described above. Preferable examples thereof include an alkyl group having 1 or 2 carbon atoms. All of $R^a$, $R^b$, and $R^c$

particularly preferably represent a hydrogen atom.

A counter salt Ya is not particularly limited, and examples thereof include various cations or anions. Examples of the cation include lithium ion ($Li^+$), cesium ion ($Cs^+$), sodium ion ($Na^+$), potassium ion ($K^+$), silver ion ($Ag^+$), copper ion ($Cu^+$), ammonium ion ($NR^d{}_4{}^+$), phosphonium ion ($PR^d{}_4{}^+$), and the like. $R^d$ represents a hydrogen atom or a substituent. Examples of the substituent include the substituent $W^P$ described above. Examples of the anion include halide ion (fluoride ion ($F^-$), iodide ion ($I^-$), bromide ion ($Br^-$), chloride ion ($Cl^-$), and the like), $O^{2-}$, and the like. Among these, halide ion is preferable, and iodide ion ($I^-$) is more preferable.

From the viewpoint of ease of substitution to the perovskite-type crystal structure, G is preferably $-OR^a$, $-O^-Ya^+$, $-SR^a$, $-S^-Ya^+$, $-NR^aR^b$, or $-(NR^aR^bR^c)^+Ya^-$, more preferably $-NR^aR^b$ or $-(NR^aR^bR^c)^+Ya^-$, even more preferably $-(NR^aR^bR^c)^+Ya^-$, and particularly preferably $-NH_3{}^+I^-$.

L represents a silyl group. Among silyl groups, a silyl group represented by Formula (L-1) is preferable.

$J^1$ represents a single bond or a linking group. In a case where $J^1$ is a linking group, the linking group is preferably at least one linking group selected from the group consisting of linking groups represented by Formula J-1 to Formula J-8. The at least one linking group selected from the group consisting of the linking groups represented by Formula J-1 to Formula J-8 includes a case in which the at least one linking group is the linking group represented by any one of Formula J-1 to Formula J-8, and a case in which the at least one linking group is a combination of at least two linking groups selected from the group consisting of the linking groups represented by Formula J-1 to Formula J-8. $J^1$ is preferably a single bond or the linking group represented by Formula J-7 or Formula J-8, and more preferably a single bond or the linking group represented by Formula J-7.

p1 represents an integer of 1 or more. p1 is preferably an integer of 1 to 4, and more preferably 1.

q1 represents an integer of 1 or more. q1 is preferably an integer of 1 to 4, and more preferably 1.

The surface treating agent represented by Formula (A-0) is preferably the surface treating agent represented by Formula (A-1) or (A-2).

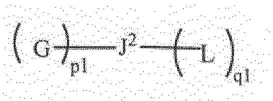

A-1

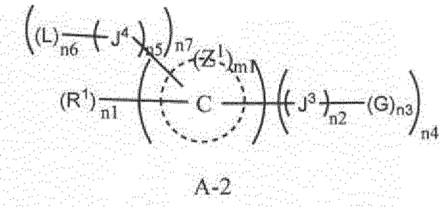

A-2

G, p1, L, and q1 of Formula (A-1) and Formula (A-2) are the same as G, p1, L, and q1 of Formula (A-0).

In Formula (A-1), $J^2$ represents a single bond or a linking group not containing a hydrocarbon ring or a hetero ring. $J^2$ is particularly preferably a linking group selected from the group consisting of an alkylene group, an alkenylene group, an alkynylene group, and a combination of these groups. Specific examples of an alkylene group, an alkenylene group, and an alkynylene group are the same as an alkylene group, an alkenylene group, and an alkynylene group of $J^4$ to be described later.

In Formula (A-1), L is preferably a silyl group represented by Formula (L-1).

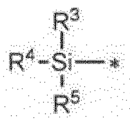

Formula L-1

In the formula, $R^3$ to $R^5$ represent an alkyl group, an alkenyl group, an alkynyl group, a hydrocarbon ring group, or a heterocyclic group. * represents a linking site with $J^2$.

The alkyl group is preferably an alkyl group having 1 to 18 carbon atoms, more preferably an alkyl group having 1 to 6 carbon atoms, and still more preferably an alkyl group having 1 to 3 carbon atoms. Examples of the alkyl group include methyl, ethyl, propyl, isopropyl, butyl, tert-butyl, pentyl, hexyl, decyl, and the like.

The alkenyl group is preferably an alkenyl group having 2 to 18 carbon atoms, and more preferably an alkenyl group having 2 to 6 carbon atoms. Examples of the alkenyl group include vinyl, allyl, butenyl, hexenyl, and the like.

The alkynyl group is preferably an alkynyl group having 2 to 18 carbon atoms, and more preferably an alkynyl group having 2 to 4 carbon atoms. Examples of the alkynyl group include ethynyl, butynyl, hexynyl, and the like.

A hydrocarbon ring may be an aromatic hydrocarbon ring or an aliphatic hydrocarbon ring.

Examples of the aromatic hydrocarbon ring include a benzene ring and a fused polybenzene ring (for example, a naphthalene ring, a phenanthrene ring). A hydrocarbon ring which is not an aromatic ring, for example, a 3- to 7-membered cycloalkane or a 5- to 7-membered cycloalkene may be fused with these rings.

The aliphatic hydrocarbon ring is preferably a 3- to 8-membered ring, more preferably a 5- or 6-membered ring, and more preferably a cyclopentane ring. Examples thereof include a cyclopentane ring, a cyclohexane ring, a cyclohexene ring, a cyclohexadiene ring, and a cyclooctane ring, and a cyclohexane ring is preferable.

The hetero ring may be an aromatic hetero ring or an aliphatic hetero ring.

In regard to the number of ring members of the aromatic hetero ring, a 3- to 8-membered ring is preferable, and a 5- or 6-membered ring is more preferable. The number of carbon atoms of the aromatic hetero ring is preferably 0 to 20, and more preferably 0 to 18.

Examples of the aromatic hetero ring include a pyrrole ring, a thiophene ring, a furan ring, an imidazole ring, a pyrazole ring, an oxazole ring, a thiazole ring, a pyridine ring, a pyrazine ring, a pyrimidine ring, a pyridazine ring, a triazine ring, an oxadiazole ring, a thiadiazole ring, an isoxazole ring, an isothiazole ring, and a triazole ring. In addition, examples of the ring that has a fused ring structure include a benzothiazole ring, a benzimidazole ring, a benzoxazole ring, an indoline ring, an indazole ring, and the like. More preferable examples thereof include a pyridine ring, a pyrrole ring, a furan ring, a triazine ring, an imidazole ring, an oxazole ring, a thiazole ring, and a thiophene ring, and even more preferable examples thereof include a pyridine ring or a thiophene ring.

In regard to the aliphatic hetero ring, a 5- to 8-membered ring is preferable, and the number of carbon atoms is preferably 0 to 24, and more preferably 1 to 18.

Examples of the aliphatic hetero ring include pyrrolidine, oxolane, thiolane, piperidine, oxane, thiane, piperazine, morpholine, quinuclidine, azetidine, oxetane, aziridine, dioxane, pentamethylene sulfide, and the like.

In Formula (A-1), G is preferably selected from the group consisting of $-OR^a$, $-O^-Ya^+$, $-SR^a$, $-S^-Ya^+$, $-NR^aR^b$, and $-(NR^aR^bR^c)^+Ya^-$, more preferably $-NR^aR^b$ or $-(NR^aR^bR^c)^+Ya^-$, even more preferably $-(NR^aR^bR^c)^+Ya^-$, and particularly preferably $-NH_3^+I^-$. Herein, $R^a$, $R^b$, and $R^c$ are the same as those of Formula (A-0).

In Formula (A-2), ring C represents a hydrocarbon ring or a hetero ring. $Z^1$ represents a hetero atom or $NR^{12}$. $R^{12}$ represents a hydrogen atom or a substituent. ml represents an integer of 0 or more. $R^1$ represents a substituent. n1 represents an integer of 0 or more. $J^3$ represents a single bond or a linking group. n2 represents an integer of 0 or more. n3 represents an integer of 1 or more. n4 represents an integer of 1 or more. $J^4$ represents a single bond or a linking group. n5 represents an integer of 0 or more. n6 represents an integer of 1 or more. n7 represents an integer of 1 or more.

The surface treating agent represented by Formula (A-2) will be described in detail.

The ring C represents a hydrocarbon ring consisting of carbon atom groups that are necessary to form a ring, or a hetero ring consisting of carbon atom groups that are necessary to form a ring and Z, in which Z represents a hetero atom or $NR^{12}$.

In Formula (A-2), a hydrocarbon ring represented by the ring C may be an aromatic hydrocarbon ring or an aliphatic hydrocarbon ring, and a hetero ring may be an aromatic hetero ring or an aliphatic hetero ring. The ring C is preferably an aromatic hydrocarbon ring or an aromatic hetero ring.

Examples of the aromatic hydrocarbon ring include a benzene ring and a fused polybenzene ring (for example, a naphthalene ring, a phenanthrene ring). A hydrocarbon ring which is not an aromatic ring, for example, a 3- to 7-membered cycloalkane or a 5- to 7-membered cycloalkene may be fused with these rings. The aromatic hydrocarbon ring represented by the ring C is preferably a benzene ring.

The aliphatic hydrocarbon ring is the same as the aliphatic hydrocarbon ring represented by $R^3$ to $R^5$ in Formula (L-1) described above, and a preferable range thereof is also the same.

In regard to the aromatic hetero ring, a 5- to 7-membered ring is preferable, and a 5- or 6-membered ring is more preferable. In addition, a hetero ring containing an aromatic hydrocarbon ring, an aliphatic hydrocarbon ring other than aromatic (for example, cycloalkane, cycloalkene), or an aromatic hetero ring may be fused to these rings. A hetero atom represented by Z is preferably a nitrogen atom, an oxygen atom, or a sulfur atom, and more preferably a nitrogen atom or a sulfur atom.

$R^{12}$ represents a hydrogen atom or a substituent. In a case where $R^{12}$ represents a substituent, examples of the substituent include the substituent $W^P$ described above. Among these, an alkyl group having 1 to 30 carbon atoms is preferable, and an alkyl group having 1 to 15 carbon atoms is more preferable. $R^{12}$ is even more preferably a hydrogen atom.

In addition, ml represents an integer of 0 or more, and in a case where ml is 2 or more, a plurality of Z's may be the same as or different from each other. ml is preferably an integer of 0 to 2. In a case where the ring C represents an aromatic hetero ring, ml is preferably 1 or 2, and more preferably 1.

Examples of such an aromatic hetero ring include a pyrrole ring, a thiophene ring, a furan ring, an imidazole ring, a pyrazole ring, an oxazole ring, a thiazole ring, a pyridine ring, a pyrazine ring, a pyrimidine ring, a pyridazine ring, a triazine ring, an oxadiazole ring, a thiadiazole ring, an isoxazole ring, an isothiazole ring, and a triazole ring. In addition, examples of the ring that has a fused ring structure include a benzothiazole ring, a benzimidazole ring, a benzoxazole ring, an indoline ring, an indazole ring, and the like. More preferable examples thereof include a pyridine ring, a pyrazine ring, a pyrimidine ring, a pyridazine ring, a triazine ring, a thiazole ring, and a thiophene ring, and even more preferable

examples thereof include a pyridine ring or a thiophene ring.

The aliphatic hetero ring is the same as the aliphatic hetero ring represented by $R^3$ to $R^5$ in Formula (L-1) described above, and a preferable range thereof is also the same.

$R^1$ represents a substituent. Examples of the substituent represented by $R^1$ include substituents other than the group corresponding to G among the above-described substituent $W^P$, and a nitro group. Among these, examples thereof include a halogen atom, an alkyl group, an alkenyl group, an alkynyl group, an alkoxy group, an alkylthio group, an aryl group, a heteroaryl group, a nitro group, and a cyano group. In addition, a case in which at least one hydrogen atom of each substituent of an alkyl group, an alkenyl group, an alkynyl group, an alkoxy group, an alkylthio group, an aryl group, or a heteroaryl group, is further substituted by a halogen atom, and thus results in a group having a halogen atom (also referred to as "group having a halogen atom") is also preferable. The group having a halogen atom is preferably an alkyl group substituted with a halogen atom, and more preferably an alkyl group substituted with a fluorine atom.

Examples of the halogen atoms represented by $R^1$ include a fluorine atom, a chlorine atom, a bromine atom, and an iodine atom. Preferable examples thereof include a fluorine atom.

The alkyl group is preferably an alkyl group having 1 to 18 carbon atoms, more preferably an alkyl group having 1 to 6 carbon atoms, and still more preferably an alkyl group having 1 to 3 carbon atoms. Examples of the alkyl group include methyl, ethyl, propyl, isopropyl, butyl, tert-butyl, pentyl, hexyl, decyl, and the like.

The alkenyl group is preferably a linear alkenyl group or a branched alkenyl group having 2 to 20 carbon atoms, and preferable examples thereof include ethenyl, 1-propenyl, 2-propenyl, 1-butenyl, 4-pentenyl, and butadiene. Furthermore, in the alkenyl group, sis-trans isomerism is not particularly limited.

The alkynyl group is preferably a linear alkynyl group or branched alkynyl group having 2 to 20 carbon atoms, and preferable examples thereof include ethynyl and butynyl.

An alkyl moiety of the alkoxy group and the alkylthio group is preferably the same as the alkyl group described above. This alkoxy group may be substituted. Examples of the substituent include the substituent $W^P$ described above. The substituted alkoxy group is preferably a 2-methoxyethyloxy group.

Examples of the aryl group and the heteroaryl group are the same as the aromatic hydrocarbon ring and the aromatic hetero ring described in the ring C, and preferable examples thereof include a benzene ring, a pyridine ring, and a thiophene ring.

$R^1$ is preferably an alkyl group, a branched alkyl group, a halogen atom, or a group having a halogen atom, more preferably a branched alkyl group, a halogen atom, or a group having a halogen atom, and even more preferably a branched alkyl group, or an alkyl group substituted with a halogen atom.

n1 represents an integer of 0 or more. n1 is preferably an integer of 0 to 2, more preferably an integer of 0 or 1, and even more preferably 1.

$J^3$'s each independently represent a single bond or a linking group. In a case where $J^3$ is a linking group, the linking group is preferably at least one linking group selected from the group consisting of linking groups represented by Formula J-1 to Formula J-8. $J^3$ is preferably a single bond, or at least one linking group selected from the group consisting of the linking groups represented by Formula J-1, Formula J-6, and Formula J-7. In the case where $J^3$ is a linking group, a preferable linking group is a combination including Formula J-1, Formula J-6, or Formula J-7, among the combinations described above. The linking group of $J^3$ is more preferably a single bond or a linking group formed by a combination of two of the linking group represented by Formula J-1, the linking group represented by Formula J-7, and the linking group represented by Formula J-1, or a linking group formed by a combination of one linking group represented by Formula J-6 and one linking group represented by Formula J-7.

In Formula (A-2), G is preferably selected from the group consisting of $-OR^a$, $-O^-Ya^+$, $-SR^a$, $-S^-Ya^+$, $-NR^aR^b$, and $-(NR^aR^bR^c)^+Ya^-$, more preferably $-NR^aR^b$ or $-(NR^aR^bR^c)^+Ya^-$, even more preferably $-(NR^aR^bR^c)^+Ya^-$, and particularly preferably $-NH_3^+I^-$. Herein, $R^a$, $R^b$, and $R^c$ are the same as those of Formula (A-0).

In Formula (A-2), a binding site of a "$-(J^3)_{n2}-(G)_{n3}$" group to the ring C is not particularly limited. In a case where the ring C is an aromatic hetero ring, at least one binding site of a "$-(J^3)_{n2}-(G)_{n3}$" group (in a case where a hetero atom is position 1) is preferably at position 2 of the ring C (atom adjacent to the hetero atom).

n3 represents an integer of 1 or more. n3 is preferably 1 to 3, more preferably 1 or 2, and even more preferably 1.

n4 represents an integer of 1 or more, and is preferably 1 to 4, and more preferably 1 or 2.

In Formula (A-2), L is preferable a silyl group represented by Formula (L-1), as described in Formula (A-1). A silyl group represented by Formula (L-1) in Formula (A-2) is the same as that of Formula (A-1) described above, except that the silyl group is linked to $J^4$ or the ring C.

$J^4$'s each independently represent a single bond or a linking group. In a case where $J^4$ is a linking group, the linking group is preferably at least one linking group selected from the group consisting of linking groups represented by Formula J-1 to Formula J-8. $J^4$ is preferably a single bond, or at least one linking group selected from the group consisting of the linking groups represented by Formula J-1, Formula J-6, and Formula J-7. In the case where $J^4$ is a linking group, a preferable linking group is a combination including Formula J-1, Formula J-6, or Formula J-7, among the combinations described above. The linking group of $J^4$ is more preferably a single bond or a linking group formed

by a combination of two of the linking group represented by Formula J-1, the linking group represented by Formula J-7, and the linking group represented by Formula J-1, or a linking group formed by a combination of one linking group represented by Formula J-6 and one linking group represented by Formula J-7.

$J^4$ is particularly preferably a linking group selected from the group consisting of an alkylene group, a cycloalkylene group, an alkenylene group, a cycloalkenylene group, an alkynylene group, an arylene group, a heteroarylene group, and a combination of these groups.

Examples of the alkylene group include methylene, ethylene, propylene, isopropylene, butylene, tert-butylene, pentylene, hexylene, decylene, and the like.

Examples of the cycloalkylene group include cyclopropylene, cyclopentylene, cyclohexylene, and the like.

Examples of the alkenylene group include vinylene, allylene, butenylene, hexenylene, and the like.

Examples of the cycloalkenylene group include cyclopropenylene, cyclopentenylene, cyclohexenylene, and the like.

Examples of the alkynylene group include ethynylene, butynylene, hexynylene, and the like.

Examples of the arylene group include phenylene.

Examples of the heteroarylene group include a group based on a 5-membered aromatic hetero ring, a fused hetero ring containing a 5-membered aromatic hetero ring, a 6-membered aromatic hetero ring, and a fused hetero ring containing a 6-membered aromatic hetero ring.

Examples of one aspect of the compound represented by Formula (A-2) include Formula (A-3).

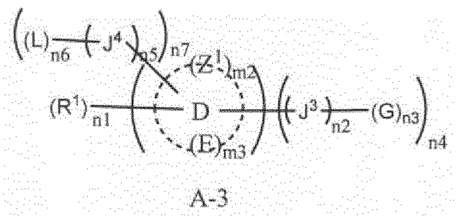

A-3

In Formula (A-3), a ring D represents a hetero ring. $Z^1$ is the same as that of Formula (A-2). m2 represents an integer of 1 or more. E represents $>C=CR^{Y1}R^{Y2}$, $>C=S$, $>C=O$, or $>C=NR^{Y3}$. $R^{Y1}$ and $R^{Y2}$ each independently represent a substituent. $R^{Y3}$ represents a hydrogen atom or a substituent. m3 represents an integer of 0 or more. In a case where $R^{Y1}$, $R^{Y2}$, and $R^{Y3}$ represent a substituent, the substituent is not particularly limited, and examples thereof include the substituent $W^P$ described above. Preferable examples thereof include an alkyl group having 1 or 2 carbon atoms.

$R^1$, n1, $J^3$, n2, G, n3, n4, $J^4$, n5, L, n6, and n7 are the same as those of Formula (A-2).

The hetero ring as the ring D may be an aromatic hetero ring or an aliphatic hetero ring.

Examples of the aromatic hetero ring include a pyrrole ring, a thiophene ring, a furan ring, an imidazole ring, a pyrazole ring, an oxazole ring, a thiazole ring, a pyridine ring, a pyrazine ring, a pyrimidine ring, a pyridazine ring, a triazine ring, an oxadiazole ring, a thiadiazole ring, an isoxazole ring, an isothiazole ring, and a triazole ring. In addition, examples of the ring that has a fused ring structure include a benzothiazole ring, a benzimidazole ring, a benzoxazole ring, an indoline ring, an indazole ring, and the like. More preferable examples thereof include a pyridine ring, a pyrazine ring, a pyrimidine ring, a pyridazine ring, a triazine ring, a thiazole ring, and a thiophene ring, and even more preferable examples thereof include a pyridine ring or a thiophene ring.

As the aliphatic hetero ring, a 5- to 8-membered ring is preferable, and examples thereof include pyrrolidine, oxolane, thiolane, piperidine, oxane, thiane, piperazine, morpholine, quinuclidine, azetidine, oxetane, aziridine, dioxane, pentamethylene sulfide, and the like.

The linking groups represented by Formula J-1 to Formula J-8 which are preferable as the linking groups $J^1$, $J^2$, and $J^3$ of the surface treating agent represented by Formula (A-0), (A-1), (A-2), or (A-3) will be described.

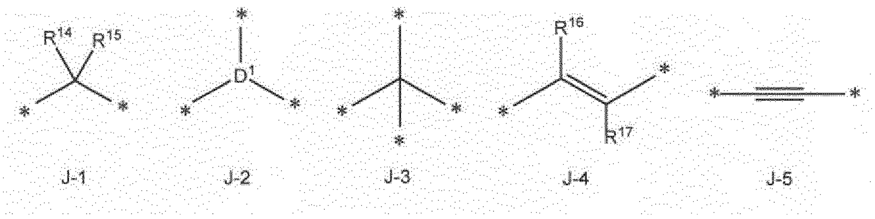

J-1 J-2 J-3 J-4 J-5

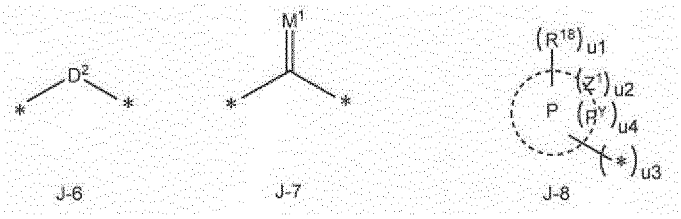

J-6 J-7 J-8

In Formula, * represents a binding site to G, L, or the ring C, or a binding site to another linking group represented by any one of Formula J-1 to Formula J-8.

$D^1$ represents a nitrogen atom, $N^+R^{19}$, or $CR^{20}$.

$D^2$ represents an oxygen atom, a sulfur atom, or $NR^{21}$, and preferably represents $NR^{21}$.

$M^1$ represents an oxygen atom, a sulfur atom, or $NR^{22}$, and preferably represents an oxygen atom or $NR^{22}$.

$Z^1$ represents a hetero atom or $NR^{13}$. Examples of the hetero atom include a nitrogen atom, an oxygen atom, or a sulfur atom, and a sulfur atom is preferable.

$P^Y$ is a group having ">C=" in $P^Y$ as a ring-constituting atom of a ring P, and two single bonds of the carbon atom are respectively bonded to the ring-constituting atoms of the ring P, and therefore the carbon atom is incorporated into the ring P. $P^Y$ specifically preferably represents $>C=CR^{Y1}R^{Y2}$, >C=S, or >C=O, and >C=O is preferable.

The ring P represents an aliphatic hydrocarbon ring consisting of carbon atom groups that are necessary to form a ring, or an aliphatic hetero ring consisting of carbon atom groups that are necessary to form a ring and $Z^1$. The aliphatic hydrocarbon ring is preferably a 3- to 8-membered ring, and more preferably a 5- or 6-membered ring. Examples thereof include a cyclopentane ring, a cyclohexane ring, a cyclohexene ring, a cyclohexadiene ring, and a cyclooctane ring, and a cyclohexane ring is preferable. As the aliphatic hetero ring, a 5- to 8-membered ring is preferable, and examples thereof include pyrrolidine, oxolane, thiolane, piperidine, oxane, thiane, piperazine, morpholine, quinuclidine, pyrrolidine, azetidine, oxetane, aziridine, dioxane, pentamethylene sulfide, and the like.

$R^{14}$ to $R^{17}$, and $R^{19}$ and $R^{20}$ each independently represent a hydrogen atom or a substituent. $R^{18}$, $R^{Y1}$, and $R^{Y2}$ represent a substituent. Examples of a substituent in the case where $R^{14}$ to $R^{17}$, and $R^{19}$ and $R^{20}$ represent a substituent, and a substituent of $R^{18}$, $R^{Y1}$, and $R^{Y2}$ include the substituent $W^P$ described above. Among those, an alkyl group and a halogen atom are preferable, and a halogen atom is more preferable. As the alkyl group, a substituted or unsubstituted linear or branched alkyl group having 1 to 30 carbon atoms is preferable. In a case where the alkyl group has a substituent, the substituent is not particularly limited, and the above-described substituent $W^P$ is preferable, and a halogen atom (fluorine atom, chlorine atom, bromine atom, and the like) is more preferable. Examples of the alkyl group include methyl, ethyl, propyl, butyl, pentyl, hexyl, heptyl, octyl, decyl, and octadecyl. It is even more preferable that $R^{14}$ to $R^{17}$, and $R^{19}$ and $R^{20}$ each independently represent a halogen atom or a hydrogen atom.

$R^{Y1}$ and $R^{Y2}$ may be bonded to each other to form a ring. The ring formed by $R^{Y1}$ and $R^{Y2}$ is not particularly limited, and may be the same ring as the ring P described above.

$R^{13}$, $R^{21}$ and $R^{22}$ each independently represent a hydrogen atom or a substituent. In a case where $R^{13}$, $R^{21}$ and $R^{22}$ represent a substituent, examples of the substituent include the substituent $W^P$ described above. Among those, an alkyl group is preferable. As the alkyl group, a substituted or unsubstituted linear or branched alkyl group having 1 to 30 carbon atoms is preferable. In a case where the alkyl group has a substituent, the substituent is not particularly limited, and the above-described substituent $W^P$ is preferable, and a halogen atom (fluorine atom, chlorine atom, bromine atom, and the like) is more preferable. Examples of the alkyl group include methyl, ethyl, propyl, butyl, pentyl, hexyl, heptyl, octyl, decyl, and octadecyl. It is even more preferable that $R^{13}$, $R^{21}$ and $R^{22}$ each independently represent an alkyl group or a hydrogen atom, and it is particularly preferable that $R^{13}$, $R^{21}$ and $R^{22}$ each independently represent a hydrogen atom.

ul represents an integer of 0 or more, and is preferably an integer of 0 to 5, and more preferably 0 or 1.

u2 represents an integer of 0 or more, and is preferably an integer of 0 to 3, more preferably 0 or 1, and even more preferably 0.

u3 represents an integer of 2 or more and is preferably 2.

u4 represents an integer of 0 or more, and, in some cases, represents an integer of 1 or more depending on the presence or absence of aromaticity of the ring P, or the like. u4 is preferably an integer of 0 to 3, more preferably an integer of 0 or 1, and even more preferably 0.

Formula J-4 is represented as a trans form, but may be a cis form.

In the present invention, a linking group formed by a combination of two or more linking groups selected from the group consisting of the linking groups represented by Formula J-1 to Formula J-8, includes a linking group in which two or more linking groups selected from the group consisting of the linking groups represented by Formula J-1 to Formula J-8, are linked to each other to form a ring structure, as long as the linking group formed by the combination has a binding site that is necessary for forming the compounds represented by any one of Formulas (A-0), (A-1), and (A-2).

In Formulas (A-0), (A-1), and (A-2), groups that can be understood as groups represented by G or L are not included in the range of the linking group.

In a case where the linking groups represented by Formula J-1 to Formula J-8 are combined, the following combinations are preferable.

A combination of a plurality of linking groups represented by Formula J-1, in which 2 to 30 linking groups are preferable, 2 to 10 linking groups are more preferable, 2 to 5 linking groups are even more preferable, and 2 to 4 linking groups are particularly preferable.

A combination of one or more linking groups represented by Formula J-1 (an upper limit thereof is not particularly limited, but may be 30 linking groups and is preferably 10 linking groups), and one or more linking groups represented by Formula J-6 (an upper limit thereof is not particularly limited, but may be 30 linking groups and is preferably 10 linking groups).

A combination of one or more linking groups represented by Formula J-6 (an upper limit thereof is not particularly limited, but may be 30 linking groups and is preferably 10 linking groups), and one or more linking groups represented by Formula J-7 (an upper limit thereof is not particularly limited, but may be 30 linking groups and is preferably 10 linking groups).

A combination of one or more linking groups represented by Formula J-4 (an upper limit thereof is not particularly limited, but may be 15 linking groups and is preferably 5 linking groups), and one or more linking groups represented by Formula J-7 (an upper limit thereof is not particularly limited, but may be 30 linking groups and is preferably 10 linking groups).

A combination of one or more linking groups represented by Formula J-1 (an upper limit thereof is not particularly limited, but may be 30 linking groups and is preferably 10 linking groups), one or more linking groups represented by Formula J-5 (an upper limit thereof is, for example, 15 linking groups, and preferably 5 linking groups), and one or more linking groups represented by Formula J-7 (an upper limit thereof is not particularly limited, but may be 30 linking groups and is preferably 10 linking groups).

A combination of one or more linking groups represented by Formula J-1 (an upper limit thereof is not particularly limited, but may be 30 linking groups and is preferably 10 linking groups), and one or more linking groups represented by Formula J-7 (an upper limit thereof is not particularly limited, but may be 30 linking groups and is preferably 10 linking groups).

Preferable examples of the linking group formed by a combination of the linking groups represented by Formula J-1 to Formula J-8 include a linking group having the following structure. Each linking group described below may further have the substituent $W^P$ described above.

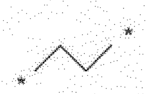
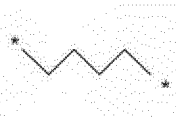
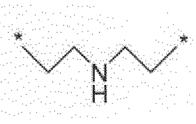
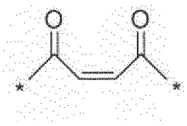

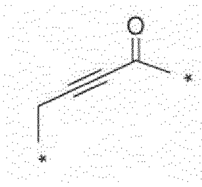
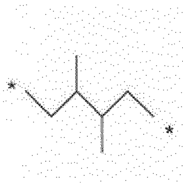
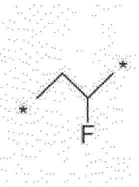
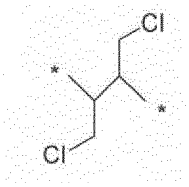

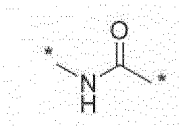
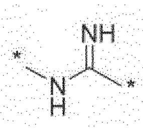
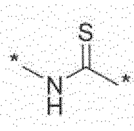
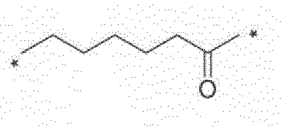

In the formula, * represents a binding site to G, L, or the ring C.

A particularly preferable aspect of the surface treating agent among the aspects of the surface treating agent of the present invention is the aspect represented by Formula (A-5).

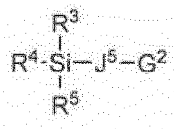 Formula A-5

In Formula (A-5), $J^5$ represents a linking group selected from the group consisting of an alkylene group, an arylene group, and a combination of these groups, and $G^2$ represents $-NR^aR^b$ or $-(NR^aR^bR^c)^+Ya^-$. $R^a$, $R^b$, $R^c$, and Ya are the same as $R^a$, $R^b$, $R^c$, and Ya in Formula (A-0). In addition, $R^3$ to $R^5$ are the same as $R^3$ to $R^5$ in Formula (L-1).

Examples of the alkylene group include methylene, ethylene, propylene, isopropylene, butylene, tert-butylene, pentylene, hexylene, decylene, and the like. Examples of the arylene group include phenylene.

Specific examples of the surface treating agent suitability used in the present invention suitability are described below, but the surface treating agent is not limited thereto.

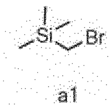
a1
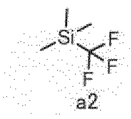
a2
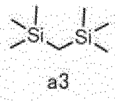
a3
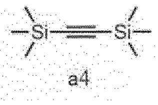
a4

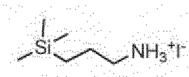
a5
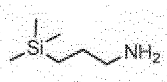
a6
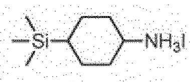
a7
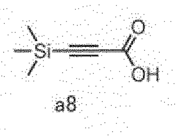
a8

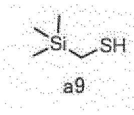
a9
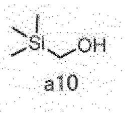
a10
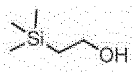
a11
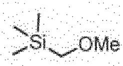
a12

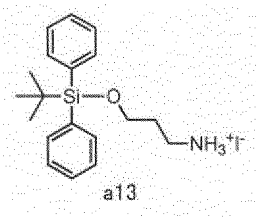
a13
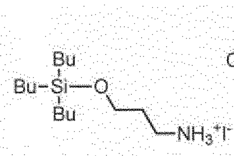
a14
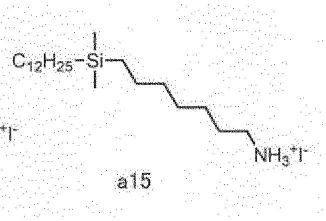
a15

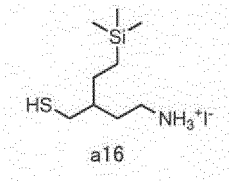
a16

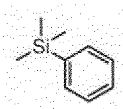
a17
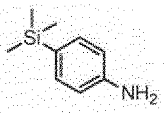
a18
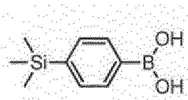
a19
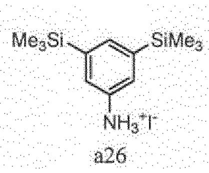
a26
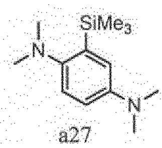
a27

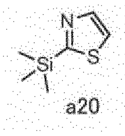
a20
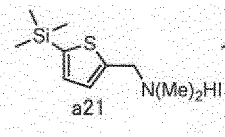
a21
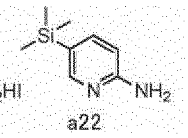
a22

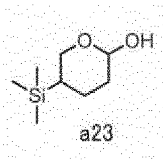
a23
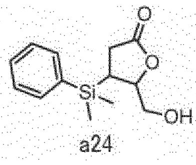
a24
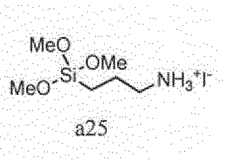
a25

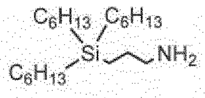
a28
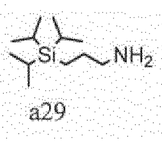
a29
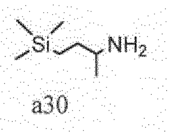
a30

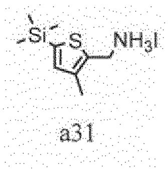
a31
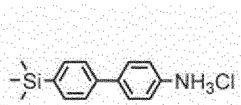
a32
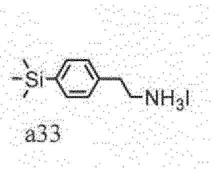
a33

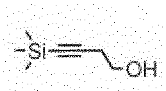
a34
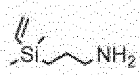
a35
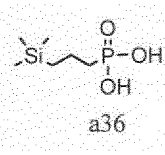
a36
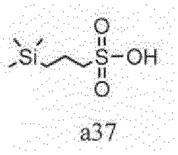
a37

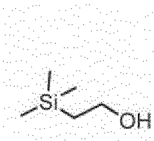
a38
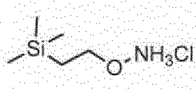
a39
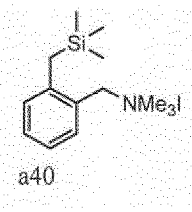
a40
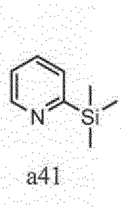
a41

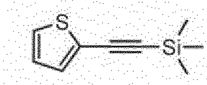
a42
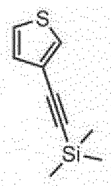
a43
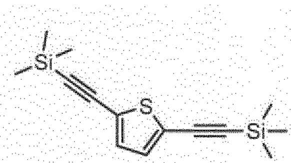
a44
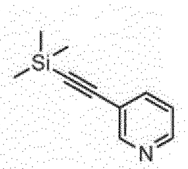
a45

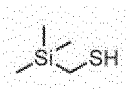
a46
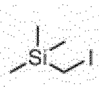
a47
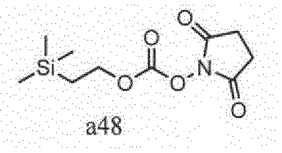
a48

<Hole Transport Layer 3>

In the photoelectric conversion element of the present invention, as in the photoelectric conversion elements 10A to 10D, an aspect in which the hole transport layer 3 is provided between the first electrode 1 and the second electrode 2 is also preferable. The hole transport layer 3 is preferably provided between the photosensitive layer 13 of the first electrode 1 and the second electrode 2, and is in contact with (laminated to) the compound layer 5.

The hole transport layer 3 includes a function of supplementing electrons to an oxidized substance of the light absorbing agent, and is preferably a solid-shaped layer (solid hole transport layer).

A hole transporting material for forming the hole transport layer 3 is not particularly limited, and examples thereof include inorganic materials such as CuI and CuNCS, organic hole transporting materials described in Paragraphs 0209 to 0212 of JP2001-291534A, and the like. As the hole transporting material, an organic hole transporting material is preferable from the viewpoint of the adhesion to the compound layer. Preferred examples of the organic hole transporting material include conductive polymers such as polythiophene, polyaniline, polypyrrole, and polysilane, spiro compounds in which two rings share a central atom such as C or Si having a tetrahedral structure, aromatic amine compounds such as triarylamine, triphenylene compounds, nitrogen-containing heterocyclic compounds, and liquid-crystalline cyano compounds.

As the hole transporting material, an organic hole transporting material which can be applied in a solution state and then has a solid shape is preferable, and specific examples thereof include 2,2',7,7'-tetrakis-(N,N-di-p-methoxyphenylamine)-9,9'-spirobifluorene (also referred to as spiro-OMeTAD), poly(3-hexylthiophene-2,5-diyl), 4-(diethylamino)benzaldehyde diphenylhydrazone, poly(3,4-ethylene dioxythiophene (PEDOT), and the like.

Although not particularly limited, the film thickness of the hole transport layer 3 is preferably 50 μm or less, more preferably 1 nm to 10 μm, still more preferably 5 nm to 5 μm, and still more preferably 10 nm to 1 μm.

The film thickness of the hole transport layer 3 corresponds to an average distance of the second electrode 2 to the surface of the compound layer 5, or to the surface of the first electrode 1, and the film thickness can be measured by observing a cross-section of the photoelectric conversion element 10 by using a scanning electron microscope (SEM) and the like.

<Electron Transport Layer 4>

In the photoelectric conversion element of the present invention, as in the photoelectric conversion element 10E, an aspect in which the electron transport layer 4 is provided between the first electrode 1 and the second electrode 2 is also preferable. In this aspect, the electron transport layer 4 is preferably in contact with (laminated to) the compound layer 5.

The electron transport layer 4 is the same as the electron transport layer 15, except that a destination of electrons is the second electrode and positions where the electrons are formed are different.

<Second Electrode 2>

The second electrode 2 functions as a positive electrode in a solar cell. The second electrode 2 is not particularly limited as long as the second electrode 2 has conductivity. Typically, the second electrode 2 can be configured to have the same configuration as that of the conductive support 11. In a case where sufficient strength is maintained, the support 11a is not necessary.

As a structure of the second electrode 2, a structure having a high current-collection effect is preferable. At least one of the conductive support 11 or the second electrode 2 needs to be substantially transparent so that light reaches the photosensitive layer 13. In the solar cell of the present invention, it is preferable that the conductive support 11 is transparent and solar light is incident from the support 11a side. In this case, it is more preferable that the second electrode 2 has a light-reflecting property.

Examples of a material used to form the second electrode 2 include metals such as platinum (Pt), gold (Au), nickel (Ni), copper (Cu), silver (Ag), indium (In), ruthenium (Ru), palladium (Pd), rhodium (Rh), iridium (Ir), osmium (Os), and aluminum (Al), the above-described conductive metal oxides, carbon materials, conductive polymers, and the like. The carbon materials may be conductive materials formed through bonding of carbon atoms, and examples thereof include fullerene, a carbon nanotube, graphite, graphene, and the like.

As the second electrode 2, a thin film (including a thin film obtained through vapor deposition) of a metal or a conductive metal oxide, or a glass substrate or a plastic substrate which has the thin film is preferable. As the glass substrate or the plastic substrate, glass including a gold or platinum thin film or glass on which platinum is vapor-deposited is preferable.

The film thickness of the second electrode 2 is not particularly limited, and is preferably 0.01 to 100 μm, more preferably 0.01 to 10 μm, and still more preferably 0.01 to 1 μm.

<Other Configurations>

In the present invention, a spacer or a separator can also be used instead of the blocking layer 14 and the like or in combination with the blocking layer 14 and the like so as to prevent the first electrode 1 and the hole transport layer or the second electrode 2 from coming into contact with each other via a defect generated in the photosensitive layer, the compound layer, and the porous layer.

In addition, a hole blocking layer may be provided between the second electrode 2 and the hole transport layer 3.

«Solar Cell»

The solar cell of the present invention is constituted by using the photoelectric conversion element of the present invention. For example, as illustrated in Fig. 1A, Fig. 2 to Fig. 6, the photoelectric conversion element 10 having a configuration, which is allowed to operate by the external circuit 6, can be used as the solar cell. As the external circuit 6 that is connected to the first electrode 1 (the conductive support 11) and the second electrode 2, a known circuit can be used without particular limitation.

For example, the present invention is applicable to solar cells described in Science, 338, p. 643-647 (2012), J. Am. Chem. Soc., 2009, 131(17), 6050 to 6051, and Science, 338, 643 (2012).

It is preferable that a lateral surface of the solar cell of the present invention is sealed with a polymer, an adhesive, and the like so as to prevent deterioration, evaporation, and the like in constituent substances.

As described above, in the photoelectric conversion element and the solar cell of the present invention, the compound layer containing the surface treating agent having a silyl group is provided on the photosensitive layer surface, and therefore the effect in which the moisture resistance variation is small can be obtained.

« Method of Manufacturing Photoelectric Conversion Element and Solar Cell»

Other than formation of the compound layer, the photoelectric conversion element and the solar cell of the present invention can be manufactured in accordance with a known method, for example, a method described in Science, 338, p. 643-647 (2012), J. Am. Chem. Soc., 2009, 131(17), p. 6050 to 6051, Science, 338, p. 643(2012), and the like.

Hereinafter, the method for manufacturing the photoelectric conversion element and the solar cell of the present invention will be described in brief.

The method for manufacturing the photoelectric conversion element and the solar cell of the present invention is not particularly limited as long as the method includes a step for bringing, into contact with a solution containing the compound represented by Formula (A-0), the first electrode that has, on the conductive support, the photosensitive layer containing, as the light absorbing agent, the compound having a perovskite-type crystal structure that has a cation of an element of Group 1 in the periodic table or a cationic organic group A, a cation of a metal atom M other than elements of Group 1 in the periodic table, and an anion of an anionic atom or atomic group X.

In the manufacturing method of the present invention, first, at least one of the blocking layer 14, the porous layer 12, the electron transport layer 15, or the hole transport layer 16 is formed on a surface of the conductive support 11 according to the purpose.

For example, the blocking layer 14 can be formed by a method in which a dispersion, which contains the insulating substance or a precursor compound thereof, and the like, is applied to the surface of the conductive support 11, and the dispersion is baked, a spray pyrolysis method, and the like.

A material that forms the porous layer 12 is preferably used as fine particles, and more preferably a dispersion that contains the fine particles.

A method of forming the porous layer 12 is not particularly limited, and examples thereof include a wet-type method, a dry-type method, and other methods (for example, a method described in Chemical Review, Vol. 110, p. 6595 (published on 2010)). In these methods, it is preferable that the dispersion (paste) is applied to the surface of the conductive support 11 or the surface of the blocking layer 14 and then the dispersion is baked at a temperature 100°C to 800°C for ten minutes to ten hours, for example, in the air. According to this, it is possible to bring the fine particles into close contact with each other.

In a case where baking is performed a plurality of times, a temperature in baking except final baking (a baking temperature except for a final baking temperature) is preferably set to be lower than the temperature in the final firing (the final baking temperature). For example, in a case where titanium oxide paste is used, the baking temperature except for the final baking temperature can be set in a range of 50°C to 300°C. In addition, the final baking temperature can be set in a range of 100°C to 600°C to be higher than the baking temperature except for the final baking temperature. In a case where a glass support is used as the support 11a, the baking temperature is preferably 60°C to 500°C.

The amount of a porous material applied to form the porous layer 12 is appropriately set in correspondence with the film thickness of the porous layer 12, the number of times of coating, and the like, and there is no particular limitation thereto. For example, the amount of the porous material applied per 1 $m^2$ of a surface area of the conductive support 11 is preferably 0.5 to 500 g, and more preferably 5 to 100 g.

In a case where the electron transport layer 15 or the hole transport layer 16 is provided, the layer can be formed in the same manner as in the hole transport layer 3 or the electron transport layer 4 to be described below.

Subsequently, the photosensitive layer 13 is provided.

First, the light absorbing agent solution for forming the photosensitive layer 13 is prepared. The light absorbing agent solution contains $MX_2$ and AX which are raw materials of the perovskite compound. Here, A, M, and X are the same as A, M, and X in Formula (I). In the light absorbing agent solution, a molar ratio between $MX_2$ and AX is appropriately

adjusted in correspondence with the purpose. In a case of forming the perovskite compound as the light absorbing agent, the molar ratio between AX and $MX_2$ is preferably 1:1 to 10:1.

Then, the prepared light absorbing agent solution is applied to the surface of any one of the porous layer 12, the blocking layer 14, the electron transport layer 15, or the hole transport layer 16, and dried. According to the above description, the photosensitive layer 13 containing the light absorbing agent of the perovskite compound is formed on the surface of the porous layer 12, the blocking layer 14, the electron transport layer 15, or the hole transport layer 16. In regard to the drying, drying with heat is preferable, and drying is performed by heating the applied light absorbing agent solution typically at 20°C to 300°C, and preferably at 50°C to 170°C.

In addition, the photosensitive layer can also be formed in conformity to a method of synthesizing the perovskite compound.

In the manufacturing method of the present invention, the compound layer containing the surface treating agent represented by Formula (A-0) is provided on the surface of the photosensitive layer of the first electrode. The surface treating agent to be used is preferably the surface treating agent represented by Formula (A-1) or (A-2).

In order to provide the compound layer on the surface of the photosensitive layer of the first electrode, the solution containing the surface treating agent is used. This solution may be the above-described compound itself in a liquid state, or may be a solution or a surface treatment solution in a form of a suspension (dispersion). A solvent or a dispersion medium is not particularly limited, and is preferably an aprotic solvent rather than a protic solvent. Examples of the aprotic solvent include hexane, octane, decane, benzene, toluene, xylene, diethyl ether, tetrahydrofuran (THF), ethyl acetate, acetone, acetonitrile, N,N-dimethylformamide (DMF), dimethylsulfoxide (DMSO), chloroform, dichloromethane, chlorobenzene, dichlorobenzene, benzyl chloride, and the like. A concentration of the surface treating agent in the solution is not particularly limited, and is, for example, preferably 0.0001% to 100% by mass, and more preferably 0.001% to 100% by mass.

A method for bringing the prepared solution into contact with the surface of the photosensitive layer of the first electrode is not particularly limited, and examples thereof include a method for applying a solution to the surface of the first electrode, or a method for immersing the first electrode into a solution. In addition, still another example of the method includes a dry-type method such as a vacuum deposition, which uses a mixture from which the solvent of the solution is removed. A wet method is preferable. Examples of a coating method include various methods described below.

A temperature of application or immersion is preferably 5°C to 100°C. It is considered that in a case where the temperature is within this range, the structure of the perovskite layer can be maintained. An immersion time is preferably from 0.1 seconds to 24 hours, more preferably from 5 seconds to 24 hours, and even more preferably from 20 seconds to 1 hour.

After the application or the immersion, it is preferable to dry the solution. Drying conditions are not particularly limited. A drying temperature is preferably, for example, 5°C to 300°C, and more preferably 20°C to 150°C. A drying time is preferably, for example, 1 second to 48 hours, and more preferably 1 minute to 5 hours.

An applying amount of the solution containing the surface treating agent having a silyl group in this step is appropriately determined depending on the type and the like of these compounds, and the amount is not particularly limited. In the present invention, the applying amount is determined so that at least a part of the surface of the photosensitive layer of the first electrode is covered with the surface treating agent (compound layer 5) having the abundance described above. From the viewpoint of making the photosensitive layer hydrophobic and the adhesion with the adjacent layer (hole transport layer, second electrode, and the like), it is preferable that the surface of the photosensitive layer of the first electrode is uniformly covered with the compound layer containing the surface treating agent having a silyl group.

The hole transport layer 3 or the electron transport layer 4 is preferably formed on the compound layer formed as described above.

The hole transport layer 3 can be formed through application and drying of a hole transporting material solution that contains a hole transporting material. In the hole transporting material solution, a concentration of the hole transporting material is preferably 0.1 to 1.0 M (mol/L) when considering that application properties are excellent, and in a case of providing the porous layer 12, the hole transporting material solution easily intrudes into pores of the porous layer 12.

The electron transport layer 4 can be formed through application and drying of an electron transporting material solution that contains an electron transporting material.

After the hole transport layer 3 or the electron transport layer 4 is formed, the second electrode 2 is formed, thereby manufacturing the photoelectric conversion element.

The film thicknesses of the respective layers can be adjusted by appropriately changing the concentrations of respective dispersion liquids or solutions and the number of times of application. For example, in a case where the photosensitive layers 13B and 13C having a large film thickness are provided, a light absorbing agent solution may be applied and dried a plurality of times.

The respective dispersion liquids and solutions described above may respectively contain additives such as a dispersion auxiliary agent and a surfactant as necessary.

In the method for manufacturing the photoelectric conversion element, examples of the solvent or dispersion

medium that is used in a step other the step for forming the compound layer include a solvent described in JP2001-291534A, but the solvent or dispersion medium is not particularly limited thereto. In the present invention, an organic solvent is preferable, and an alcohol solvent, an amide solvent, a nitrile solvent, a hydrocarbon solvent, a lactone solvent, a halogen solvent, and a mixed solvent of two or more kinds thereof are preferable. As the mixed solvent, a mixed solvent of the alcohol solvent and a solvent selected from the amide solvent, the nitrile solvent, and the hydrocarbon solvent is preferable. Specifically, methanol, ethanol, isopropanol, γ-butyrolactone, chlorobenzene, acetonitrile, N,N'-dimethylformamide (DMF), dimethylacetamide, and a mixed solvent thereof are preferable.

A method of applying the solutions or dispersants which form the respective layers is not particularly limited, and it is possible to use a known application method such as spin coating, extrusion die coating, blade coating, bar coating, screen printing, stencil printing, roll coating, curtain coating, spray coating, dip coating, an inkjet printing method, and an immersion method. Among these, spin coating, screen printing, and the like are preferable.

The photoelectric conversion element of the present invention may be subjected to an efficiency stabilizing treatment such as annealing, light soaking, and being left as is in an oxygen atmosphere as necessary.

The photoelectric conversion element prepared as described above can be used as a solar cell after connecting the external circuit 6 to the first electrode 1 and the second electrode 2.

Examples

Hereinafter, the present invention will be described in more detail based on examples, but the present invention is not limited to the following examples.

Example 1

[Manufacturing of Photoelectric Conversion Element (Sample No. 101)]

The photoelectric conversion element 10A illustrated in Fig. 1A was manufactured in the following procedure. A case in which the film thickness of the photosensitive layer 13 is large, corresponds to the photoelectric conversion element 10B illustrated in Fig. 2.

<Production of Conductive Support 11>

A fluorine-doped $SnO_2$ conductive film having a film thickness of 300 nm as the transparent electrode 11b was formed on a glass substrate having a thickness of 2 mm as the support 11a, and therefore a conductive support 11 was produced.

<Preparation of Solution for Blocking Layer>

An isopropanol solution (manufactured by Sigma-Aldrich Co. LLC) of 15% by mass of titanium diisopropoxide bis(acetylacetonate) was diluted with 1-butanol, and therefore 0.02 M solution for a blocking layer was prepared.

<Formation of Blocking Layer 14>

The blocking layer 14 with a film thickness of 50 nm formed from titanium oxide was formed on the $SnO_2$ conductive film of the conductive support 11 with a spray pyrolysis method at 450°C using the prepared 0.02 M solution for the blocking layer.

<Preparation of Titanium Oxide Paste>

Ethyl cellulose, lauric acid, and terpineol were added to an ethanol dispersion liquid of anatase-type titanium oxide having an average particle size of 20 nm, and therefore titanium oxide paste was prepared.

<Formation of Porous Layer 12>

The prepared titanium oxide paste was applied onto the blocking layer 14 with a screen printing method, and was baked in the air at 500°C for 3 hours. A baked body of the titanium oxide obtained was immersed in 40 mM $TiCl_4$ aqueous solution, and then was heated at 60°C for 1 hour, and heating was continuously performed at 500°C for 30 minutes, and therefore the porous layer 12 with a film thickness of 250 nm formed from $TiO_2$ was formed.

<Formation of Photosensitive Layer 13A>

27.86 mL of a methanol solution of 40% by mass of methyl amine, and 30 mL of an aqueous solution of 57% by mass of hydrogen iodide (hydroiodic acid) were stirred in a flask at 0°C for 2 hours, and were concentrated, and therefore coarse $CH_3NH_3I$ was obtained. The coarse $CH_3NH_3I$ obtained was dissolved in ethanol and was recrystallized with diethylether. A precipitated crystal was filtered and collected, and was dried under reduced pressure at 60°C for 5 hours, and therefore purified $CH_3NH_3I$ was obtained.

Then, the purified $CH_3NH_3I$ and $PbI_2$ were stirred and mixed in dimethylformamide (N,N-dimethylformamide: DMF) by a molar ratio of 3:1 at 60°C for 12 hours, and the resultant mixture was filtered with a polytetrafluoroethylene (PTFE) syringe filter, and therefore a 40% by mass light absorbing agent solution A was obtained.

The prepared light absorbing agent solution A was applied onto the porous layer 12 with a spin coating method under conditions of 60 seconds at 2000 rpm, and the applied light absorbing agent solution A was dried by using a hot plate at 100°C for 60 minutes, and therefore the photosensitive layer 13A including a perovskite compound of $CH_3NH_3PbI_3$ was obtained. A total film thickness of the porous layer 12 and the photosensitive layer 13A was 300 nm.

In this manner, the first electrode 1A was produced.

<Preparation of Surface Treatment Solution A1>

20 mg of compound a1 was dissolved in 2 mL of benzyl chloride and the insoluble matter was filtered with a polytetrafluoroethylene (PTFE) syringe filter, and therefore a surface treatment solution A1 was obtained.

<Formation of Compound Layer 5A>

Next, the surface treatment solution A1 was applied to the surface of the first electrode 1A of 25 mm square by the spin coating method under conditions at 3000 rpm for 30 seconds, and then the applied solution was dried by using the hot plate at 100°C for 30 minutes. In this manner, the compound layer 5A was formed.

<Preparation of Hole Transporting Material Solution>

180 mg of 2,2',7,7'-tetrakis-(N,N-di-p-methoxyphenylamine)-9,9'-spirobifluorene (spiro-OMeTAD) as the hole transporting material was dissolved in 1 mL of chlorobenzene. In addition, 170 mg of lithium-bis(trifluoromethanesulfonyl) imide was dissolved in 1 mL of acetonitrile, and therefore an acetonitrile solution was prepared. 37.5 $\mu$L of the obtained acetonitrile solution and 17.5 $\mu$L of t-butylpyridine (TBP) were added to and mixed with the above chlorobenzene solution, and therefore a hole transporting material solution was prepared.

<Formation of Hole Transport Layer 3>

Next, the prepared solution for a hole transport layer was applied to the compound layer 5A formed on the surface of the first electrode 1A by a spin coating method and was dried, and therefore the hole transport layer 3A with a film thickness of 100 nm was formed.

<Formation of Second Electrode 2>

Gold was vapor-deposited on the hole transport layer 3A, and therefore the second electrode 2 with a film thickness of 100 nm was produced.

In this manner, the photoelectric conversion element 10A (Sample No. 101) was manufactured.

The film thickness of each layer was measured by observing the cross section of the photoelectric conversion element 10 with a scanning electron microscope (SEM).

[Manufacturing of Photoelectric Conversion Element (Sample Nos. 102 to 124)]

Photoelectric conversion elements of the present invention (sample Nos. 102 to 124) were respectively manufactured in the same manner as the manufacturing of the photoelectric conversion element (sample No. 101) except that a benzyl chloride solution containing each of compounds described in Table 1 was used instead of the compound a1 as the surface treating agent in the manufacturing of the photoelectric conversion element (sample No. 101).

[Manufacturing of Photoelectric Conversion Element (Sample No. 125)]

A photoelectric conversion element of the present invention (sample No. 125) was manufactured in the same manner as the manufacturing of the photoelectric conversion element (sample No. 103) except that isopropyl alcohol (IPA) was used instead of benzyl chloride as the solvent of the surface treatment solution in the manufacturing of the photoelectric conversion element (sample No. 103).

[Manufacturing of Photoelectric Conversion Element (Sample No. 126)]

A photoelectric conversion element (Sample No. 126) of the present invention was manufactured in the same manner as in the manufacturing of the photoelectric conversion element (Sample No. 103) except that $CH_3NH_3PbBr_3$ was used instead of $CH_3NH_3PbI_3$ as the perovskite compound in the manufacturing of the photoelectric conversion element (Sample No. 103).

[Manufacturing of Photoelectric Conversion Element (Sample No. 127)]

A photoelectric conversion element (Sample No. 127) of the present invention was manufactured in the same manner as in the manufacturing of the photoelectric conversion element (Sample No. 103) except that $HC(=NH)NH_3PbI_3$ was used instead of $CH_3NH_3PbI_3$ as the perovskite compound, and a drying temperature of the surface treatment solution was changed to 150°C by using chlorobenzene instead of benzyl chloride in the manufacturing of the photoelectric conversion element (Sample No. 103).

[Manufacturing of Photoelectric Conversion Element (Sample No. 128)]

A photoelectric conversion element of the present invention (sample No. 128) was manufactured in the same manner as the manufacturing of the photoelectric conversion element (sample No. 105) except that isopropyl alcohol (IPA) was used instead of benzyl chloride as the solvent of the surface treatment solution in the manufacturing of the photoelectric conversion element (sample No. 105).

[Manufacturing of Photoelectric Conversion Element (Sample Nos. 129 to 132 and 136)]

Photoelectric conversion elements of the present invention (sample Nos. 129 to 132 and 136) were manufactured in the same manner as the manufacturing of the photoelectric conversion elements (sample Nos. 103, 104, 112, and 115) except that solvents described in Table 2 were used instead of benzyl chloride as the solvent of the surface treatment solution in the manufacturing of the photoelectric conversion elements (sample Nos. 103, 104, 112, and 115).

[Manufacturing of Photoelectric Conversion Element (Sample Nos. 133 to 135)]

Photoelectric conversion elements of the present invention (sample Nos. 133 to 135) were manufactured in the same manner as the manufacturing of the photoelectric conversion element (sample No. 101) except that compounds described in Table 2 were used instead of the compound a1 as the surface treating agent and the solvents described in Table 2 were used instead of benzyl chloride as the solvent of the surface treatment solution in the manufacturing of the photoelectric conversion element (sample No. 101).

[Manufacturing of Photoelectric Conversion Element (Sample No. c101)]

A photoelectric conversion element for comparison (sample No. c101) was manufactured in the same manner as the manufacturing of the photoelectric conversion element (sample No. 101) except that the surface treatment solution was not applied in the manufacturing of the photoelectric conversion element (sample No. 101).

[Manufacturing of Photoelectric Conversion Element (Sample No. c102)]

A photoelectric conversion element for comparison (sample No. c102) was manufactured in the same manner as the manufacturing of the photoelectric conversion element (sample No. 101) except that only benzyl chloride was used instead of the surface treatment solution in the manufacturing of the photoelectric conversion element (sample No. 101).

[Manufacturing of Photoelectric Conversion Element (Sample No. c103)]

A photoelectric conversion element for comparison (sample No. c103) was manufactured in the same manner as the manufacturing of the photoelectric conversion element (sample No. 101) except that only the compound c1 was used instead of the surface treatment solution consisting of the benzyl chloride solution containing the compound a1 in the manufacturing of the photoelectric conversion element (sample No. 101).

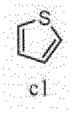

c1

[Manufacturing of Photoelectric Conversion Element (Sample No. c104)]

A photoelectric conversion element for comparison (sample No. c104) was manufactured in the same manner as the manufacturing of the photoelectric conversion element (sample No. 101) except that a benzyl chloride solution containing the compound c1 was used instead of the benzyl chloride solution containing the compound a1 as the surface treatment liquid in the manufacturing of the photoelectric conversion element (sample No. 101).

<Evaluation of Moisture Resistance Variation>

A moisture resistance variation of the photoelectric conversion element was evaluated as follows.

A battery characteristic test was conducted on the photoelectric conversion elements of each sample number within 1 hour after the manufacture. The battery characteristic test was performed by irradiating each photoelectric conversion element with pseudo-solar light of 1000 $W/m^2$ from a xenon lamp through an AMI.5 filter by using a solar simulator "WXS-85H" (manufactured by Wacom). In this battery characteristic test, current-voltage characteristics were measured by using an I-V tester, and therefore an initial photoelectric conversion efficiency $\eta^I$ (%) was obtained.

Subsequently, the photoelectric conversion element of each sample number was left to stand for 24 hours under a high humidity environment of 30°C and 60% RH. Thereafter, the battery characteristic test was performed on the photoelectric conversion element of each sample number in the same manner as the measurement of the photoelectric conversion efficiency $\eta^I$. According to this battery characteristic test, a time-dependent photoelectric conversion efficiency $\eta^R$ (%) after a lapse of 24 hours was obtained. The same measurements were performed on 6 specimens of each sample number.

Based on the initial photoelectric conversion efficiency $\eta^I$ and the time-dependent photoelectric conversion efficiency $\eta^R$ after a lapse of 24 hours obtained in the above manner, a deterioration rate in photoelectric conversion efficiency was calculated by Formula (I).

$$\text{Deterioration rate (\%)} = 100 - \{100 \times [(\text{time-dependent photoelectric conversion efficiency } \eta^R)/(\text{initial photoelectric conversion efficiency } \eta^I)]\} \qquad \text{(I)}$$

Next, an average deterioration rate of the photoelectric conversion efficiency of the six specimens of photoelectric conversion elements in each of the sample numbers was calculated in accordance with Expression (II).

$$\text{Average deterioration rate (\%)} = 100 - \{100 \times [(\text{average time-dependent photoelectric conversion efficiency } \eta^{RA})/(\text{average initial photoelectric conversion efficiency } \eta^{IA})]\} \qquad \text{(II)}$$

The moisture resistance variation of the photoelectric conversion element was evaluated as follows. That is, when an average deterioration rate of the photoelectric conversion efficiency, which was calculated by Expression (II), was set as "1", a range of the six specimens, of which a difference of a relative deterioration rate from the average deterioration rate was largest was classified under the following evaluation standard so as to be evaluated.

The phrase "difference of the relative deterioration rate being largest" indicates a difference in which 1 is subtracted from a value obtained by dividing each of the deterioration rates of the six specimens by the average deterioration rate, and an absolute value thereof is largest.

- Evaluation Standard of Moisture Resistance Variation -

The range having a maximum value among the differences of the relative deterioration rates was classified according to the following standard to evaluate the variation in photoelectric conversion efficiency. In this case, whether the maximum value of the differences (absolute value) was larger or smaller than the average value (standard "1") was not distinguished.

In the evaluation of the moisture resistance variation, [A], [B], [C], [D], and [E] are passing levels, [A], [B], and [C] are preferable, and [A] is more preferable. On the other hand, in regard to [F], the moisture resistance variation between the elements is large and thus does not reach the passing level (required level) of the present invention.

A: Maximum value is in a range of ±0.16
B: Maximum value is beyond a range of ±0.16 and is in a range of ±0.20
C: Maximum value is beyond a range of ±0.20 and is in a range of ±0.24
D: Maximum value is beyond a range of ±0.24 and is in a range of ±0.28
E: Maximum value is beyond a range of ±0.28 and is in a range of ±0.32
F: Maximum value is beyond a range of ±0.32

The results are shown in Table 1 and Table 2.

[Table 1]

| Sample No. | Photosensitive layer | Surface treating agent | Solvent | Moisture resistance variation |
|---|---|---|---|---|
| 101 | $CH_3NH_3PbI_3$ | a1 | Benzyl chloride | D |
| 102 | $CH_3NH_3PbI_3$ | a3 | Benzyl chloride | D |
| 103 | $CH_3NH_3PbI_3$ | a5 | Benzyl chloride | A |
| 104 | $CH_3NH_3PbI_3$ | a6 | Benzyl chloride | A |
| 105 | $CH_3NH_3PbI_3$ | a7 | Benzyl chloride | B |
| 106 | $CH_3NH_3PbI_3$ | a8 | Benzyl chloride | C |
| 107 | $CH_3NH_3PbI_3$ | a9 | Benzyl chloride | B |
| 108 | $CH_3NH_3PbI_3$ | a10 | Benzyl chloride | B |
| 109 | $CH_3NH_3PbI_3$ | a11 | Benzyl chloride | B |
| 110 | $CH_3NH_3PbI_3$ | a12 | Benzyl chloride | B |
| 111 | $CH_3NH_3PbI_3$ | a13 | Benzyl chloride | C |
| 112 | $CH_3NH_3PbI_3$ | a15 | Benzyl chloride | A |
| 113 | $CH_3NH_3PbI_3$ | a16 | Benzyl chloride | C |
| 114 | $CH_3NH_3PbI_3$ | a17 | Benzyl chloride | D |
| 115 | $CH_3NH_3PbI_3$ | a18 | Benzyl chloride | A |
| 116 | $CH_3NH_3PbI_3$ | a19 | Benzyl chloride | C |
| 117 | $CH_3NH_3PbI_3$ | a20 | Benzyl chloride | D |
| 118 | $CH_3NH_3PbI_3$ | a21 | Benzyl chloride | B |
| 119 | $CH_3NH_3PbI_3$ | a22 | Benzyl chloride | B |
| 120 | $CH_3NH_3PbI_3$ | a23 | Benzyl chloride | C |
| 121 | $CH_3NH_3PbI_3$ | a24 | Benzyl chloride | C |
| 122 | $CH_3NH_3PbI_3$ | a25 | Benzyl chloride | E |
| 123 | $CH_3NH_3PbI_3$ | a26 | Benzyl chloride | A |
| 124 | $CH_3NH_3PbI_3$ | a27 | Benzyl chloride | A |

(continued)

| Sample No. | Photosensitive layer | Surface treating agent | Solvent | Moisture resistance variation |
|---|---|---|---|---|
| 125 | $CH_3NH_3PbI_3$ | a5 | IPA | B |
| 126 | $CH_3NH_3PbBr_3$ | a5 | Benzyl chloride | A |

[Table 2]

| Sample No. | Photosensitive layer | Surface treating agent | Solvent | Moisture resistance variation |
|---|---|---|---|---|
| 127 | $HC(=NH)NH_3PbI_3$ | a5 | Chlorobenzene | A |
| 128 | $CH_3NH_3PbI_3$ | a7 | IPA | C |
| 129 | $CH_3NH_3PbI_3$ | a5 | Chlorobenzene | A |
| 130 | $CH_3NH_3PbI_3$ | a6 | Chlorobenzene | A |
| 131 | $CH_3NH_3PbI_3$ | a15 | Chlorobenzene | A |
| 132 | $CH_3NH_3PbI_3$ | a18 | Chlorobenzene | A |
| 133 | $CH_3NH_3PbI_3$ | a36 | Chlorobenzene | C |
| 134 | $CH_3NH_3PbI_3$ | a39 | Chlorobenzene | D |
| 135 | $CH_3NH_3PbI_3$ | a45 | Chlorobenzene | D |
| 136 | $CH_3NH_3PbI_3$ | a5 | Toluene | A |
| c101 | $CH_3NH_3PbI_3$ | None | None | F |
| c102 | $CH_3NH_3PbI_3$ | None | Benzyl chloride | F |
| c103 | $CH_3NH_3PbI_3$ | c1 | None | F |
| c104 | $CH_3NH_3PbI_3$ | c1 | Benzyl chloride | F |

As shown in Tables 1 and 2, the moisture resistance variation was reduced in all of the photoelectric conversion elements of the present invention having the compound layer containing the surface treating agent having a silyl group on the surface of the photosensitive layer.

There was a tendency that the moisture resistance variation was relatively reduced in the photoelectric conversion element using the surface treating agent represented by Formula (A-0), Formula (A-1), or Formula (A-2), compared to the photoelectric conversion element using the surface treating agent that is not included in these formulas.

Among the surface treating agents represented by Formula (A-0), Formula (A-1), or Formula (A-2), the moisture resistance variation was further reduced in the photoelectric conversion element using the surface treating agent that satisfies at least one of conditions, and the moisture resistance variation was significantly reduced in the photoelectric conversion element using the surface treating agent that satisfies all of the conditions, the conditions being (1) a silyl group L is a group represented by Formula (L-1), (2) the linking group $J^2$ is selected from an alkylene group, an alkenylene group, and an alkynylene group, or the linking group $J^4$ is selected from an alkylene group, a cycloalkylene group, an alkenylene group, a cycloalkenylene group, an alkynylene group, an arylene group, and a heteroarylene group, and (3) a polar group G is selected from $-OR^a$, $-O^-Ya^+$, $-SR^a$, $-S^-Ya^+$, $-NR^aR^b$, and $-(NR^aR^bR^c)^+Ya^-$.

On the other hand, the moisture resistance variation was large in all of the photoelectric conversion elements (sample Nos. c101, c102, c103, and c104) which did not have, on the surface of the photosensitive layer, the compound layer containing the surface treating agent having a silyl group.

Based on the comparison between the sample number 125 and the sample number 103 and the comparison between the sample number 105 and the sample number 128, it was found that rather than containing of the surface treating agent and the protic solvent, containing of the surface treating agent and the aprotic solvent as the surface treatment solution is suitable for manufacturing the photoelectric conversion element in which the moisture resistance variation is suppressed.

Next, an example of the photoelectric conversion element in which the compound layer on the surface of the photosensitive layer is formed by using the composition for surface treatment which contains the surface treating agent and the additive will be described.

[Manufacturing of Photoelectric Conversion Element (Sample No. 201)]

A photoelectric conversion element (Sample No. 201) of the present invention was manufactured in the same manner as in the manufacturing of the photoelectric conversion element (Sample No. 127) except that a surface treatment solution in which a surface treating agent a5 and an additive $CH(=NH)NH_3I$ were dissolved in chlorobenzene by a molar ratio of 1:1 so that each concentration became $2.5 \times 10^{-3}$ M, was used instead of a surface treatment solution containing the surface treating agent a5 in the manufacturing of the photoelectric conversion element (Sample No. 127).

[Manufacturing of Photoelectric Conversion Element (Sample No. 202)]

A photoelectric conversion element (Sample No. 202) of the present invention was manufactured in the same manner as in the manufacturing of the photoelectric conversion element (Sample No. 101) except that a surface treatment solution in which the surface treating agent a5 and an additive $CH_3NH_3I$ were dissolved in chlorobenzene by a molar ratio of 1:1 so that each concentration became $2.5 \times 10^{-3}$ M, was used instead of a surface treatment solution containing a surface treating agent a1 in the manufacturing of the photoelectric conversion element (Sample No. 101).

[Manufacturing of Photoelectric Conversion Element (Sample No. 203)]

A photoelectric conversion element (Sample No. 203) of the present invention was manufactured in the same manner as in the manufacturing of the photoelectric conversion element (Sample No. 101) except that the surface treatment solution in which the surface treating agent a5 and the additive $CH(=NH)NH_3I$ were dissolved in chlorobenzene by a molar ratio of 1:1 so that each concentration became $2.5 \times 10^{-3}$ M, was used instead of the surface treatment solution containing the surface treating agent a1 in the manufacturing of the photoelectric conversion element (Sample No. 101).

[Manufacturing of Photoelectric Conversion Element (Sample Nos. 204 and 205)]

Photoelectric conversion elements (Sample Nos. 204 and 205) of the present invention were manufactured in the same manner as in the manufacturing of the photoelectric conversion element (Sample No. 202) except that a surface treating agent a7 was used instead of the surface treating agent a5, and a solvent described in Table 3 was used in the manufacturing of the photoelectric conversion element (Sample No. 202).

[Manufacturing of Photoelectric Conversion Element (Sample Nos. 206 and 207)]

Photoelectric conversion elements (Sample Nos. 206 and 207) of the present invention were manufactured in the same manner as in the manufacturing of the photoelectric conversion element (Sample No. 203) except that the surface treating agent a7 was used instead of the surface treating agent a5, and the solvent described in Table 3 was used in the manufacturing of the photoelectric conversion element (Sample No. 203).

[Manufacturing of Photoelectric Conversion Element (Sample No. 208)]

A photoelectric conversion element (Sample No. 208) of the present invention was manufactured in the same manner as in the manufacturing of the photoelectric conversion element (Sample No. 203) except that the surface treating agent a7 was used instead of the surface treating agent a5, and the solvent described in Table 3 was used in the manufacturing of the photoelectric conversion element (Sample No. 203).

[Manufacturing of Photoelectric Conversion Element (Sample No. 209)]

A photoelectric conversion element (Sample No. 209) of the present invention was manufactured in the same manner as in the manufacturing of the photoelectric conversion element (Sample No. 206) except that CsI was used instead of $CH(=NH)NH_3I$ as the additive in the manufacturing of the photoelectric conversion element (Sample No. 206).

[Manufacturing of Photoelectric Conversion Element (Sample No. c201)]

A photoelectric conversion element (Sample No. c201) of the comparative example was manufactured in the same manner as in the manufacturing of the photoelectric conversion element (Sample No. c101) except that $CH(=NH)NH_3PbI_3$ was used instead of $CH_3NH_3PbI_3$ in the manufacturing of the photoelectric conversion element (Sample No. c101).

[Table 3]

| Sample No. | Photosensitive layer | Surface treating agent | Additive | Solvent | Moisture resistance variation |
|---|---|---|---|---|---|
| 201 | $HC(=NH)NH_3PbI_3$ | a5 | $HC(=NH)NH_3I$ | Chlorobenzene | A |
| 202 | $CH_3NH_3PbI_3$ | a5 | $CH_3NH_3I$ | Chlorobenzene | A |
| 203 | $CH_3NH_3PbI_3$ | a5 | $HC(=NH)NH_3I$ | Chlorobenzene | A |
| 204 | $CH_3NH_3PbI_3$ | a7 | $CH_3NH_3I$ | IPA | B |
| 205 | $CH_3NH_3PbI_3$ | a7 | $CH_3NH_3I$ | Chlorobenzene | A |
| 206 | $CH_3NH_3PbI_3$ | a7 | $HC(=NH)NH_3I$ | IPA | A |
| 207 | $CH_3NH_3PbI_3$ | a7 | $HC(=NH)NH_3I$ | Chlorobenzene | A |
| 208 | $CH_3NH_3PbI_3$ | a7 | $HC(=NH)NH_3I$ | Chloroform | A |
| 209 | $CH_3NH_3PbI_3$ | a7 | CsI | IPA | A |
| c201 | $HC(=NH)NH_3PbI_3$ | None | None | Chlorobenzene | F |

As shown in Table 3, the moisture resistance variation was reduced in all of the photoelectric conversion elements of the present invention having the compound layer formed, on the surface of the photosensitive layer, by using the composition for surface treatment containing the surface treating agent having a silyl group and the additive. In addition, regarding the moisture resistance variation, the same tendency as the tendency of the evaluation results described in Tables 1 and 2 was recognized in Table 3.

Explanation of References

1A to 1F: first electrode

11: conductive support

11a: support

11b: transparent electrode

12: porous layer

13Ato 13C: photosensitive layer

14: blocking layer

2: second electrode

3A, 3B, 16: hole transport layer

4, 15: electron transport layer

5A, 5B, 5C: compound layer

6: external circuit (lead)

10A to 10F: photoelectric conversion element

100A to 100F: system using solar cell

M: electric motor

## Claims

**1.** A photoelectric conversion element, comprising, in this order:

a first electrode that includes a photosensitive layer containing a light absorbing agent on a conductive support;
a compound layer that contains a surface treating agent and is provided on a surface of the photosensitive layer; and
a second electrode,
wherein the light absorbing agent contains a compound having a perovskite-type crystal structure that has a cation of an element of Group 1 in the periodic table or a cationic organic group A, a cation of a metal atom M other than elements of Group 1 in the periodic table, and an anion of an anionic atom or atomic group X, and the surface treating agent contains a silyl group.

**2.** The photoelectric conversion element according to claim 1,
wherein the surface treating agent is represented by Formula (A-0),

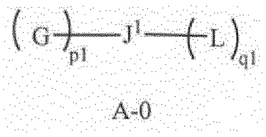

A-0

in Formula (A-0),
G represents a group or a salt selected from the group consisting of $-OR^a$, $-O^-Ya^+$, $-SR^a$, $-S^-Ya^+$, $-NR^aR^b$, $-(NR^aR^bR^c)^+Ya^-$, $-COOR^a$, $-COOYa^+$, $-SO_3R^a$, $-SO_3^-Ya^+$, $-P(=O)(OR^a)_2$, $-P(=O)(O^-Ya^+)_2$, $-B(OR^a)_2$, and $-B(OR^a)_3^-Ya^+$, $R^a$, $R^b$, and $R^c$ each independently represent a hydrogen atom or a substituent, Ya represents a counter salt, p1 represents an integer of 1 or more, L represents a silyl group, q1 represents an integer of 1 or more, and $J^1$ represents a single bond or a linking group.

**3.** The photoelectric conversion element according to claim 2,
wherein the surface treating agent is represented by Formula (A-1) or (A-2),

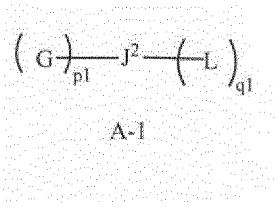

A-1

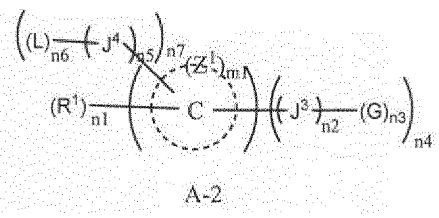

A-2

G, p1, L, and q1 of Formula (A-1) and Formula (A-2) are the same as G, p1, L, and q1 of Formula (A-0),
in Formula (A-1), $J^2$ represents a single bond or a linking group not containing a hydrocarbon ring or a hetero ring,
in Formula (A-2),
ring C represents a hydrocarbon ring or a hetero ring, $Z^1$ represents a hetero atom or $NR^{12}$, $R^{12}$ represents a hydrogen atom or a substituent, m1 represents an integer of 0 or more, $R^1$ represents a substituent, n1 represents an integer of 0 or more, $J^3$ represents a single bond or a linking group, n2 represents an integer of 0 or more, n3 represents an integer of 1 or more, n4 represents an integer of 1 or more, $J^4$ represents a single bond or a linking group, n5 represents an integer of 0 or more, n6 represents an integer of 1 or more, and n7 represents an integer of 1 or more.

4. The photoelectric conversion element according to claim 3, wherein in Formula (A-1), L is represented by Formula (L-1),

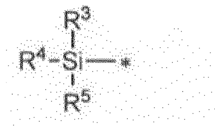

Formula L-1

in Formula, $R^3$ to $R^5$ each independently represent an alkyl group, an alkenyl group, an alkynyl group, a hydrocarbon ring group, or a heterocyclic group, and * represents a linking site with $J^2$.

5. The photoelectric conversion element according to claim 3, wherein in Formula (A-2), L is represented by Formula (L-1),

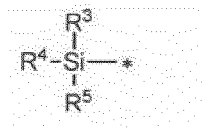

Formula L-1

in Formula, $R^3$ to $R^5$ each independently represent an alkyl group, an alkenyl group, an alkynyl group, a hydrocarbon ring group, or a heterocyclic group, and * represents a linking site with $J^4$ or ring C.

6. The photoelectric conversion element according to any one of claims 3 to 5, wherein in Formula (A-1), $J^2$ is a linking group selected from the group consisting of an alkylene group, an alkenylene group, an alkynylene group, and a combination of these groups.

7. The photoelectric conversion element according to any one of claims 3 to 6, wherein in Formula (A-2), $J^4$ is a linking group selected from the group consisting of an alkylene group, a cycloalkylene group, an alkenylene group, a cycloalkenylene group, an alkynylene group, an arylene group, a heteroarylene group, and a combination of these groups.

8. The photoelectric conversion element according to any one of claims 2 to 7, wherein in Formula (A-0), (A-1), or (A-2), G is selected from the group consisting of $-OR^a$, $-O^-Ya^+$, $-SR^a$, $-S^-Ya^+$, $-NR^aR^b$, and $-(NR^aR^bR^c)^+Ya^-$.

9. The photoelectric conversion element according to any one of claims 1 to 8, wherein the surface treating agent is represented by Formula (A-5),

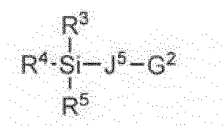

Formula A-5

in Formula (A-5), $J^5$ represents a linking group selected from the group consisting of an alkylene group, an arylene group, and a combination of these groups, and $G^2$ represents $-NR^aR^b$ or $-(NR^aR^bR^c)^+Ya^-$, $R^a$, $R^b$, and $R^c$ each independently represent a hydrogen atom or a substituent, Ya represents a counter salt, and $R^3$ to $R^5$ each independently represent an alkyl group, an alkenyl group, an alkynyl group, a hydrocarbon ring group, or a heterocyclic group.

10. A solar cell that uses the photoelectric conversion element according to any one of claims 1 to 9.

11. A method for manufacturing a photoelectric conversion element including a first electrode that has, on a conductive support, a photosensitive layer containing, as a light absorbing agent, a compound having a perovskite-type crystal structure that has a cation of an element of Group 1 in the periodic table or a cationic organic group A, a cation of a metal atom M other than elements of Group 1 in the periodic table, and an anion of an anionic atom or atomic

group X, and a second electrode in this order, the method comprising:
bringing the first electrode into contact with a solution containing a compound represented by Formula (A-0),

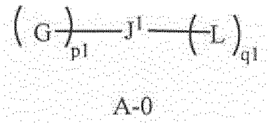

A-0

in Formula (A-0),
G represents a group or a salt selected from the group consisting of $-OR^a$, $-O^-Ya^+$, $-SR^a$, $-S^-Ya^+$, $-NR^aR^b$, $-(NR^aR^bR^c)^+Ya^-$, $-COOR^a$, $-COO^-Ya^+$, $-SO_3R^a$, $-SO_3^-Ya^+$, $-P(=O)(OR^a)_2$, $-P(=O)(O^-Ya^+)_2$, $-B(OR^a)_2$, and $-B(OR^a)_3^-Ya^+$, $R^a$, $R^b$, and $R^c$ each independently represent a hydrogen atom or a substituent, Ya represents a counter salt, p1 represents an integer of 1 or more, L represents a silyl group, q1 represents an integer of 1 or more, and $J^1$ represents a single bond or a linking group.

**12.** A surface treating agent that is represented by Formula (A-1) or (A-2),

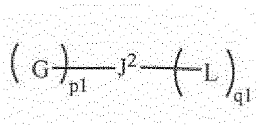

A-1

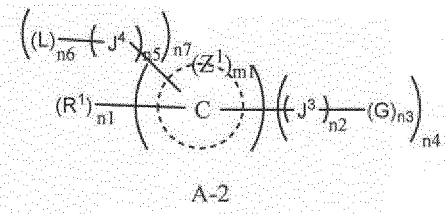

A-2

in Formula (A-1), G represents a group or a salt selected from the group consisting of $-OR^a$, $-O^-Ya^+$, $-SR^a$, $-S^-Ya^+$, $-NR^aR^b$, $-(NR^aR^bR^c)^+Ya^-$, $-COOR^a$, $-COO^-Ya^+$, $-SO_3R^a$, $-SO_3^-Ya^+$, $-P(=O)(OR^a)_2$, $-P(=O)(O^-Ya^+)_2$, $-B(OR^a)_2$, and $-B(OR^a)_3^-Ya^+$, $R^a$, $R^b$, and $R^c$ each independently represent a hydrogen atom or a substituent, Ya represents a counter salt, p1 represents an integer of 1 or more, L represents a silyl group, q1 represents an integer of 1 or more, and $J^2$ represents a single bond or a linking group not containing a hydrocarbon ring or a hetero ring, and
in Formula (A-2), G represents a group or a salt selected from the group consisting of $-OR^a$, $-O^-Ya^+$, $-SR^a$, $-S^-Ya^+$, $-NR^aR^b$, $-(NR^aR^bR^c)^+Ya^-$, $-COOR^a$, $-COO^-Ya^+$, $-SO_3R^a$, $-SO_3^-Ya^+$, $-P(=O)(OR^a)_2$, $-P(=O)(O^-Ya^+)_2$, $-B(OR^a)_2$, and $-B(OR^a)_3^-Ya^+$, $R^a$, $R^b$, and $R^c$ each independently represent a hydrogen atom or a substituent, Ya represents a counter salt, L represents a silyl group, ring C represents a hydrocarbon ring or a hetero ring, $Z^1$ represents a hetero atom or $NR^{12}$, $R^{12}$ represents a hydrogen atom or a substituent, m1 represents an integer of 0 or more, $R^1$ represents a substituent, n1 represents an integer of 0 or more, $J^3$ represents a single bond or a linking group, n2 represents an integer of 0 or more, n3 represents an integer of 1 or more, n4 represents an integer of 1 or more, $J^4$ represents a single bond or a linking group, n5 represents an integer of 0 or more, n6 represents an integer of 1 or more, and n7 represents an integer of 1 or more.

**13.** A composition for surface treatment, comprising:

the surface treating agent according to claim 12; and
an additive that has an element of Group 1 in the periodic table or a cationic organic group A.

**14.** The composition for surface treatment according to claim 13,
wherein the cationic organic group A is a cationic organic group represented by Formula (1):

Formula (1): $R^{1a}-NH_3^+$

in Formula, $R^{1a}$ represents a substituent or Formula (2), and

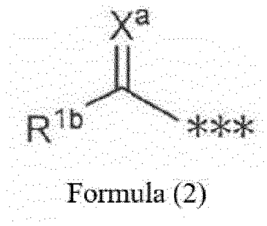

Formula (2)

in Formula (2), $X^a$ represents $NR^{1c}$, an oxygen atom, or a sulfur atom, $R^{1b}$ and $R^{1c}$ each independently represent a hydrogen atom or a substituent, and *** represents a binding site with a nitrogen atom in Formula (1).

**15.** The composition for surface treatment according to claim 14,
wherein $R^{1a}$ in Formula (1) is a group represented by Formula (2).

**16.** A surface treatment solution, comprising:

the surface treating agent according to claim 12 or the composition for surface treatment according to any one of claims 13 to 15; and
an aprotic solvent.

FIG. 1A

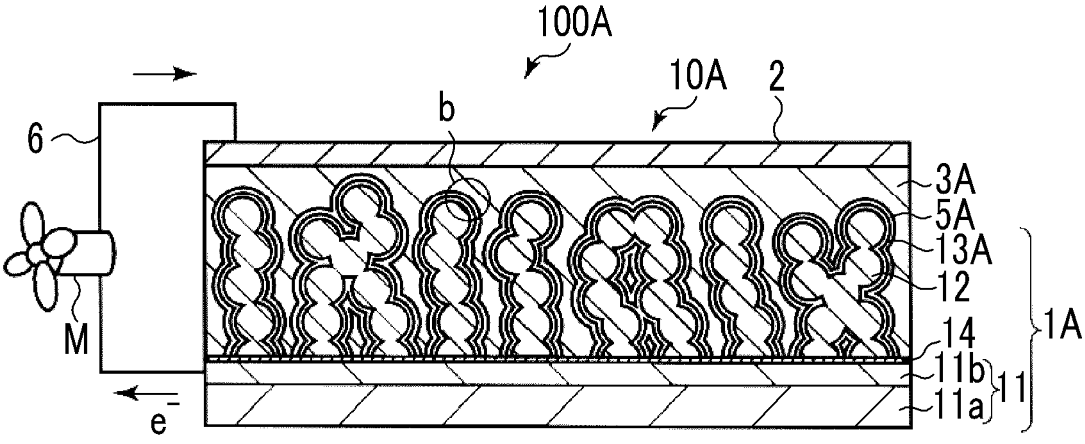


FIG. 1B

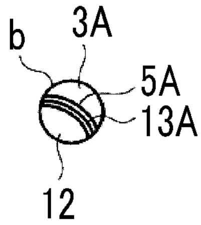


FIG. 2

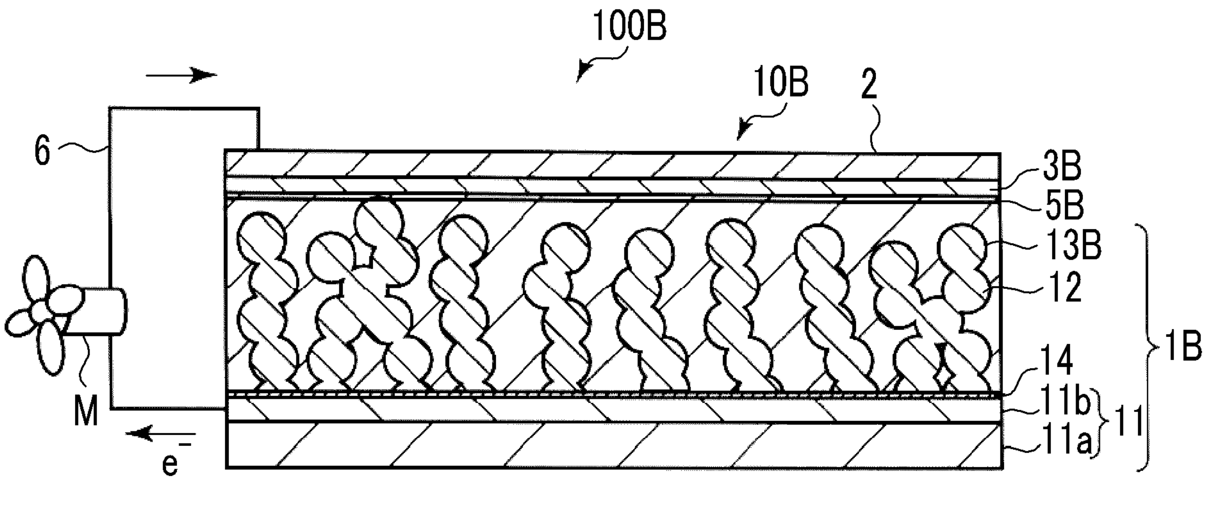

FIG. 3

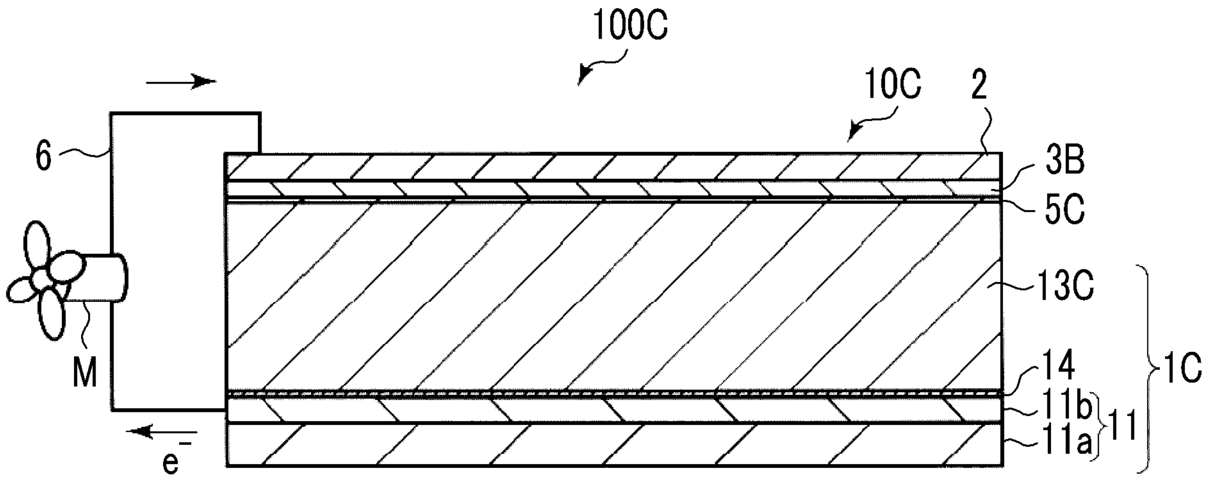
100C
10C
2
6
3B
5C
13C
M
14
1C
11b
11
11a
e⁻

FIG. 4

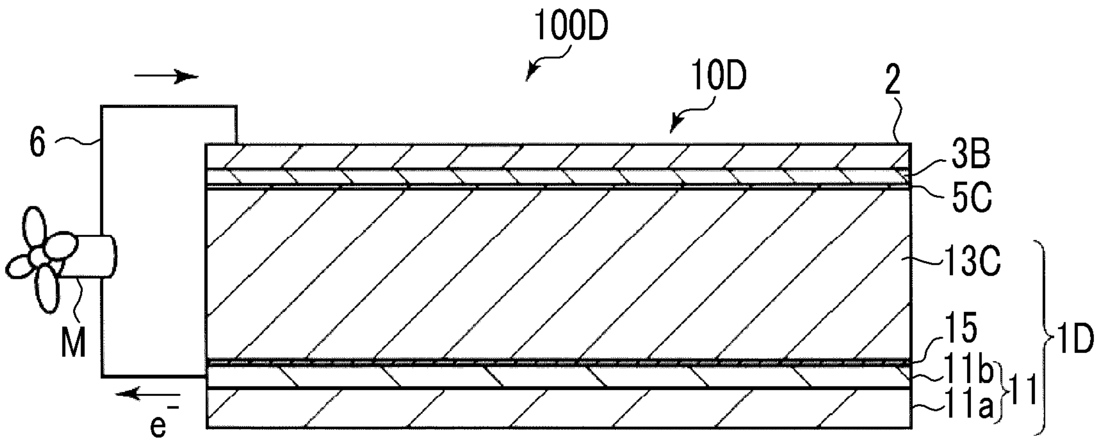
100D
10D
2
6
3B
5C
13C
M
15
1D
11b
11
11a
e⁻

FIG. 5

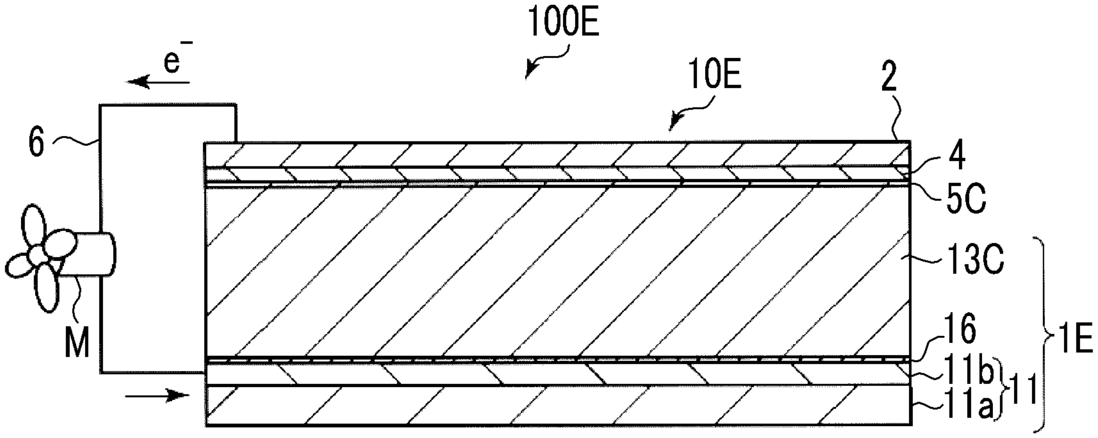
100E
e⁻
10E
2
6
4
5C
13C
M
16
1E
11b
11
11a

FIG. 6

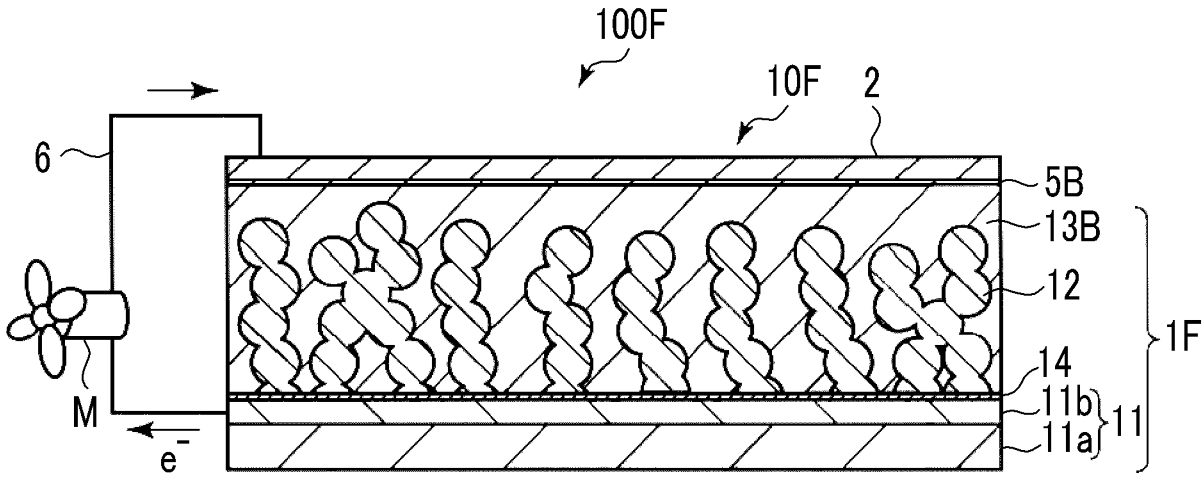
100F
10F
2
6
5B
13B
12
1F
14
M
11b
11
11a
e⁻

FIG. 7A

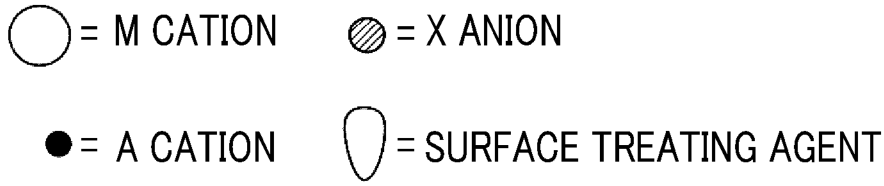


FIG. 7B

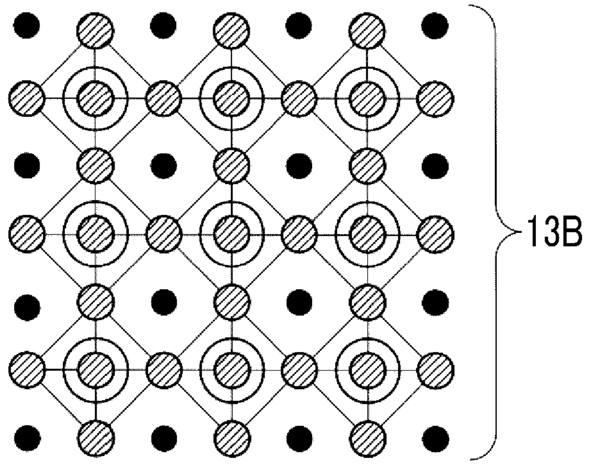


FIG. 7C

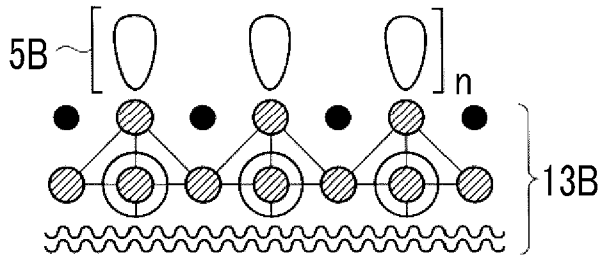

FIG. 7D

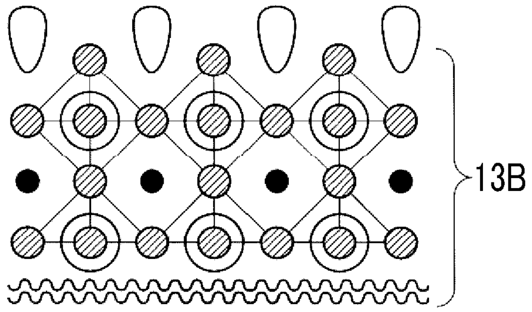


FIG. 7E

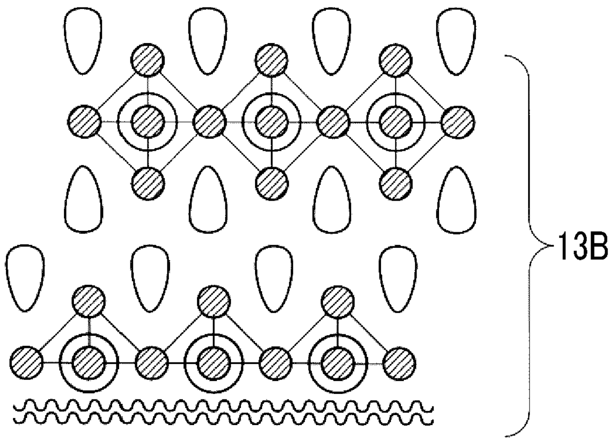


FIG. 7F

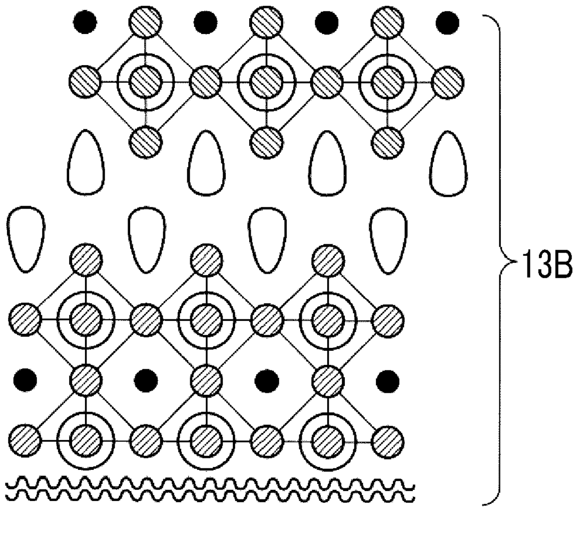

## INTERNATIONAL SEARCH REPORT

International application No. PCT/JP2017/005126

A. CLASSIFICATION OF SUBJECT MATTER
*H01L51/44*(2006.01)i, *C07F7/12*(2006.01)i, *H01L51/48*(2006.01)i

According to International Patent Classification (IPC) or to both national classification and IPC

B. FIELDS SEARCHED

Minimum documentation searched (classification system followed by classification symbols)
H01L51/42-51/48, C07F7/12

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)
JSTPlus(JDreamIII), JST7580(JDreamIII)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | ZHANG,J. et al., Bifunctional alkyl chain barriers for efficient perovskite solar cells, CHEMICAL COMMUNICATIONS, 2015.03.12, Vol.51, pp.7047-7050 | 1-3,5,7-8, 10-12<br>4,6,9,16<br>13-15 |
| X | HORANTNER,M. T. et al., Shunt-Blocking Layers for Semitransparent Perovskite Solar Cells, ADVANCED MATERIALS INTERFACES, 2016.02.22, Vol.3, pp.1500837-1-7 | 1,10-11 |
| X | CN 104576930 A (Ningbo University), 29 April 2015 (29.04.2015), paragraphs [0032] to [0064] (Family: none) | 1-3,5,7-8, 10-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 April 2017 (17.04.17) | 16 May 2017 (16.05.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

INTERNATIONAL SEARCH REPORT

International application No. PCT/JP2017/005126

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2013-168583 A (Toagosei Co., Ltd.), 29 August 2013 (29.08.2013), paragraphs [0010] to [0020] (Family: none) | 4,6,9,16 |
| A | US 2015/0380170 A1 (SHARP LABORATORIES OF AMERICA, INC.), 31 December 2015 (31.12.2015), paragraphs [0031] to [0060]; fig. 3 to 6 & WO 2016/002213 A1 | 1-16 |
| A | JP 2014-175473 A (Osaka Gas Co., Ltd.), 22 September 2014 (22.09.2014), paragraph [0067] (Family: none) | 1-16 |
| P,X | WO 2016/143526 A1 (Fujifilm Corp.), 15 September 2016 (15.09.2016), paragraphs [0054] to [0108] (Family: none) | 1-12 |
| P,X | WANG, QI et al., Thin Insulating Tunneling Contacts for Efficient and Water-Resistant Perovskite Solar Cells, ADVANCED MATERIALS, 2016.05.17, Vol.28, pp.6734-6739 | 1-12 |
| P,A | JP 2016-92294 A (Fujifilm Corp.), 23 May 2016 (23.05.2016), paragraphs [0054] to [0058] (Family: none) | 1-16 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006024565 A
- JP 2001291534 A
- US 4927721 A
- US 4684537 A
- US 5084365 A
- US 5350644 A
- US 5463057 A
- US 5525440 A
- JP 7249790 A
- JP H7249790 A
- JP 2004220974 A
- JP 2008135197 A
- JP 2005135902 A
- JP 2001160425 A
- JP 2003123859 A
- JP 2002260746 A


### Non-patent literature cited in the description


- *Science,* 2012, vol. 338, 643-647
- *Science,* 2012, vol. 338, 643-643
- *J. Am. Chem. Soc.,* 2009, vol. 131 (17), 6050-6051
- *Science,* 2012, vol. 338, 643
- *Science,* 2012, vol. 338, 643-647
- **AKIHIRO KOJIMA ; KENJIRO TESHIMA ; YASUO SHIRAI ; TSUTOMU MIYASAKA.** Organometal Halide Perovskites as Visible-Light Sensitizers for Photovoltaic Cells. *J. Am. Chem. Soc.,* 2009, vol. 131 (17), 6050-6051
- *Chemical Review,* 2010, vol. 110, 6595